# EUROPEAN PATENT APPLICATION

(11) **EP 4 826 762 A1**
(43) Date of publication of application: **21.10.2026**
(21) Application number: 24903610.4
(22) Date of filing: 05.12.2024
(51) Int. Cl.: H01L 21/60, C22C 9/00, C22C 9/10, C22F 1/00, C22F 1/08, H01B 1/02, H01B 5/02

(54) **COPPER BONDING RIBBON, METHOD FOR MANUFACTURING COPPER BONDING RIBBON, AND SEMICONDUCTOR DEVICE**

(30) Priority: 13.12.2023 JP 2023210114
(71) Applicant: Tanaka Electronics Co., Ltd., Saga 842-0031 (JP)
(72) Inventor: MATSUZAWA Osamu, Kanzaki-gun, Saga 842-0031 (JP); MITOMA Shuichi, Kanzaki-gun, Saga 842-0031 (JP); MURATA Keisuke, Kanzaki-gun, Saga 842-0031 (JP); MATSUNAGA Shizu, Kanzaki-gun, Saga 842-0031 (JP)
(74) Representative: Maiwald GmbH
(86) International application number: PCT/JP2024/043105
(87) International publication number: WO 2025/126953

(57) **Abstract**

A copper bonding ribbon is capable of ensuring bond strength without damaging bonding targets; extending the service life of a cutter; and, without compromising electrical conductivity, suppressing gradual surface oxidation of the copper ribbon. The copper bonding ribbon comprises a copper alloy having a copper purity of 99.99 mass % or more. The copper alloy contains, relative to the total amount, 5 to 40 mass ppm of silver, 0 to 10 mass ppm of phosphorus, and 0 to 8 mass ppm of each of iron, silicon, arsenic, and antimony, with a total content of phosphorus, iron, silicon, arsenic, and antimony being 0 to 30 mass ppm. In a cross section perpendicular to a longitudinal direction thereof, the ratio of the coincidence site lattice boundary length to the total length of the crystal grain boundaries is 30 to less than 60%. (1) An arithmetic average roughness (Ra) of a plane thereof in the longitudinal direction is 30 nm to 150 nm, (2) an arithmetic average roughness (Ra) of the plane in a direction perpendicular to the longitudinal direction is 30 nm to 150 nm, and a value obtained by dividing (1) the arithmetic average roughness (Ra) in the longitudinal direction by (2) the arithmetic average roughness (Ra) in the direction perpendicular to the longitudinal direction is 0.75 to 1.15.

## Description

### Technical Field

The present invention relates to a copper bonding ribbon (hereinafter also referred to as a "copper ribbon"), and more particularly to a copper ribbon suitable for high-current applications such as connecting power semiconductors or connecting a bus bar of a lithium-ion battery used in an electric vehicle and electrodes of lithium-ion batteries, a method for manufacturing the same and a semiconductor device using the copper ribbon.

Generally, the term "semiconductor" is a collective term for CPUs (central processing units), memories, and the like, whose main roles are "processing," "storage," and the like. Semiconductors are used, for example, in consumer electronics such as personal computers, smartphones, and televisions. On the other hand, power semiconductors are responsible for supplying power to drive motors, charge batteries, and operate microcomputers and LSIs (Large-Scale Integrated Circuits). Power semiconductors are mainly used for changing voltage and frequency, as well as for power conversion (converting direct current into alternating current or vice versa). Power semiconductors are also referred to as power semiconductors, power devices, power elements, or power semiconductor devices.

"Inverters" installed in energy-efficient home appliances such as air conditioners, refrigerators, and washing machines are a common example of the application of such power semiconductors. Inverters control the rotational speed of a motor by converting its frequency. By freely changing the rotational speed of the motor, inverters can reduce inefficient operation of the motor, thereby contributing to energy saving. In contrast, air conditioners not equipped with inverters adjust room temperature by repeatedly starting and stopping the motor, which may cause problems such as a lack of temperature stability and high power consumption. These inverter functions are realized by performing "switching," which involves finely switching current on and off using power semiconductors (power transistors).

Power semiconductors are widely used not only in energy-saving home appliances but also in the field of transportation, such as in electric vehicles and hybrid vehicles. In the transportation field, power semiconductors such as IGBTs (Insulated Gate Bipolar Transistors), which function to convert and control power, are utilized. An IGBT includes IGBT chips, bonding wires that connect the IGBT chips (power chips) to each other, and bonding wires that connect the IGBT chips to external electrodes. For power semiconductor bonding wires, relatively thick aluminum wires having a wire diameter (diameter) of 40 µm or more and 700 µm or less are used to accommodate large currents.

As described above, general semiconductors are mainly used for low-power processing, whereas power semiconductors are considered to be entirely different in that they are mainly used for high-power control.

Bonding wires used for general semiconductors carry only small currents. Therefore, thin bonding wires having a wire diameter of 30 µm or less and made of Au, Ag, or Cu are commonly used for general semiconductors. As a bonding method, one end of the wire is melted to form a molten ball, and heat, ultrasonic waves, and pressure are then applied to the molten ball to form a first bond to a semiconductor chip electrode or the like, followed by forming a second bond to an external substrate, electrode, or the like.

On the other hand, since bonding wires used for power semiconductors need to carry large currents, relatively lowcost aluminum wires having a large wire diameter of 40 µm or more and relatively low electrical resistance are used as described above. Regarding the bonding method for bonding wires used for power semiconductors, a method is adopted in which, instead of a molten ball being formed, the wire is first bonded to an electrode or the like by applying ultrasonic waves and pressure to the wire at room temperature, followed by forming a second bond to an external substrate, electrode, or the like.

Furthermore, unlike general semiconductors, power semiconductors perform repeated switching of large currents between on and off states as described above. Therefore, it is essential to use bonding wires that can withstand thermal stress induced by repeated heat generation and cooling. In addition, since these wires are used in applications requiring extremely high safety, such as in automobiles and trains, high levels of durability and reliability are required. For the reasons stated above, bonding wires for general semiconductors and those for power semiconductors have entirely different required characteristics and properties.

In response to the adoption of the Paris Agreement at the 21 Conference of the Parties to the United Nations Framework Convention on Climate Change (COP21), which was aimed at reducing greenhouse gas emissions as a countermeasure against global warming and climate change and stipulated the reduction of such emissions from 2020 onward, the global transition toward a decarbonized society has accelerated in recent years. The automobile industry plays a significant role in this transition. Various European countries have set forth policies to completely ban the sale of internal combustion engine vehicles (gasoline and diesel vehicles) by 2035, and to shift exclusively to electric vehicles (including plug-in hybrid electric vehicles). The United States has also set a goal of having electric vehicles account for 50% of its domestic new vehicle market by 2030. This trend is similarly observed in emerging countries such as China and India. Japan has also adopted a policy to transition all new vehicle sales to electric vehicles (including hybrid vehicles) by 2035.

While the shift to electric vehicles is accelerating, there are issues that hinder their widespread adoption. These issues include a short cruising range (the distance a vehicle can travel from a fully charged state until the battery is depleted) and a lack of charging facilities (locations).

In particular, advancing the performance of power semiconductors is indispensable for extending the cruising range. Electric vehicles can travel by using an inverter, a type of power semiconductor, to convert direct current from the battery, which serves as the energy source, into alternating current to drive the motor.

Conventionally, power semiconductors have been composed of silicon (Si), however, in recent years, power semiconductors composed of silicon carbide (SiC: silicon carbide) have been commercialized. In conventional Si power semiconductors, conduction loss and switching loss occur during conduction and throughout on-off switching operations, respectively. All of these electrical energy losses are dissipated as heat from the inverter (heat generation). To suppress this heat generation, a heat dissipation mechanism is required, and inclusion of such a heat dissipation mechanism would consequently restrict the cabin space of electric vehicles, increases vehicle weight, and shorten the cruising range.

By applying SiC power semiconductors to electric vehicles, conduction loss and switching loss during conduction and throughout on-off switching operations can be reduced. Consequently, passive components such as transformers, which benefit from increased switching frequencies (higher frequencies), can be downsized, enabling the miniaturization and weight reduction of power semiconductors such as inverters. Furthermore, simplifying the heat dissipation mechanism makes the overall electric vehicle more compact (lightweight), while the high-efficiency operation of the inverter extends the cruising range per charge.

Furthermore, the deployment of battery charging infrastructure, which is critical to the widespread adoption of electric vehicles, is essential. Simultaneously, the demand for rapid charging is increasing. Consequently, there is a need for bonding wires capable of withstanding the high currents associated with rapid charging.

Amid this trend toward miniaturization and high-current capability, most bonding wires currently used in power semiconductors are made primarily of aluminum. In addition to power semiconductors, aluminum bonding wires are also used to connect bus bars of lithium-ion battery mobiles in electric vehicles to the electrodes of lithium-ion batteries. Since aluminum has higher thermal and electrical resistance, it generates significant heat when energized and exhibits low heat dissipation efficiency. Therefore, the adoption of aluminum wires may be considered to run counter to the miniaturization trend of power semiconductors. Furthermore, it has been reported that at the bonding portion of aluminum wires, which have relatively low strength, grain coarsening occurs due to heat generation by high currents, leading to the fracture of the bonding portion.

Accordingly, copper wires have emerged as a promising alternative to aluminum wires. Compared to aluminum wires, copper wires have a lower thermal and electrical resistance and thus exhibits reduced heat generation. Furthermore, their higher recrystallization temperatures allow them to withstand high-current degradation.

Furthermore, in recent years, there has been increasing expectations for copper ribbons, which offer a larger bonding area than copper wires. Because copper wires and copper ribbons are each bonded in a loop configuration extending from a first bond to a second bond, they are subjected to a bending load during the loop formation. In particular, with hard materials like copper, a large wire diameter (or thickness) can lead to cracking when the wire is bent. Therefore, when increasing the bonding area by replacing copper wires with copper ribbons, it is common to keep the copper ribbon thickness comparable to the wire diameter of the copper wire while increasing the width of the copper ribbon to ensure that it can withstand the bending stress. A larger bonding area increases the bond strength and allows for higher current-carrying capacity. However, certain challenges inherent to copper and the ribbon geometry have emerged.

As described above, copper wires suppress heat generation compared to aluminum wires and can withstand high power output. However, since copper is significantly harder and less prone to deformation than aluminum, a high bonding load is required during the bonding process of copper wires. Such a load does not pose a problem when the bonding target is a high-strength substrate that is resistant to failure even under load. However, if the target is a delicate component such as an IC chip, the hardness of copper, in conjunction with the high load, increases the risk of damaging the IC chip. Furthermore, since a copper ribbon has a larger cross-sectional area than a copper wire, its cutting area is also larger. Consequently, the combination of the hardness of copper and the large cutting area leads to a new problem: the service life of the cutter used to cut the ribbon after the second bond is significantly shortened.

A shortened cutter service life leads to more frequent replacement, which reduces productivity, increases cutting tool costs, and consequently raises overall manufacturing costs. Beyond these cost-related issues, using a worn cutter with diminished sharpness increases the likelihood of defects such as burrs or incomplete cuts on the cut surface after the cutting process.

Patent Literature 1 describes a rolled copper sheet in which the ratio of the length of special grain boundaries to the length of the total crystal grain boundary is 60% or more. The invention described in Patent Literature 1 aims to improve fatigue properties and provides no suggestion regarding the cutter service life or bond strength. Furthermore, since the material is intended for use as a wiring material for interconnectors that connect electric components, such as terminals, connectors, and lead frames, or electrodes of solar panels, the preferred range for the length of the special grain boundaries, i.e., coincidence site lattice boundaries, differs from that required for wiring materials used in power semiconductors and lithium ion batteries.

Patent Literature 2 describes an invention related to copper alloy strips for LED lead frames. In the invention described in Patent Literature 2, the average surface roughness of the strip in the rolling direction is specified for the purpose of improving the reflectivity of an Ag-plated reflective film. However, the invention described in Cited Document 2 does not contemplate use as a wiring material for power semiconductors or lithium ion batteries, and provides no suggestion regarding the cutter service life or bond strength.

The invention described in Cited Document 3 relates to an aluminum alloy ribbon having a concave end face, and aims to provide a high-strength aluminum alloy having a ribbon shape comparable to those of copper-based and iron-based materials. Cited Document 3 provides no suggestion regarding the cutter service life or bond strength of copper ribbon materials.

### Citation List

### Patent Literature

PTL 1: Japanese Patent Application Laid-Open No. 2012-062498
PTL 2: Japanese Patent Application Laid-Open No. 2014-189852
PTL 3: WO2018/181329

### Summary of Invention

### Technical Problem

As described above, the problem to be solved by the present invention is to provide a copper bonding ribbon (hereinafter also referred to as a "copper ribbon") that is capable of ensuring bond strength without damaging fragile bonding targets such as IC chips, and also a copper ribbon that contributes to extending the service life of a cutter. In addition to the above, it is an object of the present invention to provide a copper bonding ribbon capable of suppressing gradual surface oxidation without compromising electrical conductivity.

In addition, it is an object of the present invention to provide a method for manufacturing the copper ribbon and a power semiconductor device using the copper ribbon.

### Solution to Problem

As a result of intensive research, the present inventors have invented a copper bonding ribbon that can simultaneously solve a plurality of problems. Specifically, the copper bonding ribbon according to the following embodiments, the copper bonding ribbon produced by the manufacturing method according to the embodiments, and the semiconductor device ensure bond strength without damaging fragile bonding targets such as IC chips, contribute to extending the service life of a cutter for cutting the copper bonding ribbon after bonding, and suppress the gradual surface oxidation of the copper bonding ribbon without compromising electrical conductivity.

The copper ribbon of an embodiment is a copper bonding ribbon comprising a copper alloy having a copper purity of 99.99 mass % or more, wherein
the copper alloy contains, relative to a total amount, 5 mass ppm or more and 40 mass ppm or less of silver (Ag), 0 mass ppm or more and 10 mass ppm or less of phosphorus (P), and 0 mass ppm or more and 8 mass ppm or less of each of iron (Fe), silicon (Si), arsenic (As), and antimony (Sb), with a total content of phosphorus (P), iron (Fe), silicon (Si), arsenic (As), and antimony (Sb) being 0 mass ppm or more and 30 mass ppm or less,
in a cross section perpendicular to a longitudinal direction of the copper bonding ribbon, a ratio of a coincidence site lattice boundary length to a total length of crystal grain boundaries is 30% or more and less than 60%,
   (1) an arithmetic average roughness (Ra) of a plane of the copper bonding ribbon in the longitudinal direction is 30 nm or more and 150 nm or less,
   (2) an arithmetic average roughness (Ra) of the plane of the copper bonding ribbon in a direction perpendicular to the longitudinal direction is 30 nm or more and 150 nm or less, and
a value obtained by dividing (1) the arithmetic average roughness (Ra) in the longitudinal direction by (2) the arithmetic average roughness (Ra) in the direction perpendicular to the longitudinal direction is 0.75 or more and 1.15 or less.

The end face of the copper bonding ribbon of the embodiment preferably has a curvature, and a value obtained by dividing a radius of curvature by a thickness of the copper bonding ribbon is preferably 0.50 or more and 0.90 or less.

Preferably, the width of the copper ribbon of the embodiment is 0.3 mm or more and 5.0 mm or less and the thickness is 0.05 mm or more and 0.5 mm or less.

A method for manufacturing the copper ribbon of the embodiment is a method for manufacturing a copper bonding ribbon, and comprises the steps of:
preparing a bare copper wire comprising a copper alloy having a copper purity of 99.99 mass % or more, the bare copper wire containing, relative to a total amount, 5 mass ppm or more and 40 mass ppm or less of silver (Ag), 0 mass ppm or more and 10 mass ppm or less of phosphorus (P), and 0 mass ppm or more and 8 mass ppm or less of each of iron (Fe), silicon (Si), arsenic (As), and antimony (Sb), with a total content of phosphorus (P), iron (Fe), silicon (Si), arsenic (As), and antimony (Sb) being 0 mass ppm or more and 30 mass ppm or less;
drawing the bare copper wire to obtain a copper wire;
rolling the copper wire to form a copper ribbon; and
subjecting the copper ribbon to a final heat treatment by direct resistance heating, wherein
in a cross section perpendicular to a longitudinal direction of the copper bonding ribbon, a ratio of a coincidence site lattice boundary length to a total length of crystal grain boundaries is 30% or more and less than 60%,
   (1) an arithmetic average roughness (Ra) of a plane of the copper bonding ribbon in the longitudinal direction is 30 nm or more and 150 nm or less,
   (2) an arithmetic average roughness (Ra) of the plane of the copper bonding ribbon in a direction perpendicular to the longitudinal direction is 30 nm or more and 150 nm or less, and
a value obtained by dividing (1) the arithmetic average roughness (Ra) in the longitudinal direction by (2) the arithmetic average roughness (Ra) in the direction perpendicular to the longitudinal direction is 0.75 or more and 1.15 or less.

A power semiconductor device comprising: at least one substrate; at least one semiconductor element on the substrate; an electrode on a surface of the semiconductor element; an on-semiconductor-element substrate on the semiconductor element; at least one circuit pattern on the substrate; and a copper bonding ribbon configured to connect one or more selected from the group consisting of electrodes on the surface of the semiconductor element to each other; an electrode on the surface of the semiconductor element and an external electrode; an electrode on the surface of the semiconductor element and one of the circuit patterns; an electrode on the surface of the semiconductor element and a terminal; two adjacent circuit patterns of the circuit patterns to each other; one of the circuit patterns and a terminal; the substrates to each other; and the on-semiconductor-element substrate and a circuit pattern, wherein
the copper bonding ribbon comprises a copper alloy having a copper purity of 99.99 mass % or more, the copper alloy containing, relative to the total amount, 5 mass ppm or more and 40 mass ppm or less of silver (Ag), 0 mass ppm or more and 10 mass ppm or less of phosphorus (P), and 0 mass ppm or more and 8 mass ppm or less of each of iron (Fe), silicon (Si), arsenic (As), and antimony (Sb), with a total content of phosphorus (P), iron (Fe), silicon (Si), arsenic (As), and antimony (Sb) being 0 mass ppm or more and 30 mass ppm or less,
in a cross section perpendicular to a longitudinal direction of the copper bonding ribbon, the ratio of the coincidence site lattice boundary length to the total length of the crystal grain boundaries is 30% or more and less than 60%,
   (1) an arithmetic average roughness (Ra) of a plane of the copper bonding ribbon in the longitudinal direction is 30 nm or more and 150 nm or less,
   (2) an arithmetic average roughness (Ra) of the plane of the copper bonding ribbon in a direction perpendicular to the longitudinal direction is 30 nm or more and 150 nm or less, and
a value obtained by dividing (1) the arithmetic average roughness (Ra) in the longitudinal direction by (2) the arithmetic average roughness (Ra) in the direction perpendicular to the longitudinal direction is 0.75 or more and 1.15 or less.

Note that, in the present specification, the term "x to y" indicates a range of numerical values of a value x or more and a value y or less.

### Advantageous Effects of Invention

According to the copper bonding ribbon of the present invention, it is possible to simultaneously solve a plurality of problems of: ensuring bond strength without damaging fragile bonding targets such as IC chips; contributing to extending the service life of a cutter for cutting the ribbon after bonding; and suppressing gradual surface oxidation of the copper ribbon without compromising electrical conductivity.

### Brief Description of Drawings

[Fig.1] Fig. 1 is a photograph showing a portion of a cross section in a direction perpendicular to the longitudinal direction of a copper bonding ribbon according to an embodiment.
[Fig. 2] Fig. 2 is a photograph of an oblique overhead view of a copper bonding ribbon according to an embodiment, the photograph schematically showing a bonding portion in an enlarged manner.
[Fig. 3] Fig. 3 is a cross-sectional view schematically illustrating a configuration of a semiconductor device according to an embodiment.
[Fig. 4] Fig. 4 is a cross-sectional view schematically illustrating a configuration of a semiconductor device according to another embodiment.
[Fig. 5] Fig. 5 is a cross-sectional view schematically illustrating a semiconductor device according to an embodiment having circuit patterns and a ribbon connecting the circuit patterns.
[Fig. 6] Fig. 6 is a graph showing changes with time in the ratio of CuO oxide films after an exposure test in Example 6, Example 13, and Comparative Example 14.
[Fig. 7] Fig. 7 is a view schematically illustrating a part of a lithium-ion battery module.
[Fig. 8] Fig. 8 is a view schematically illustrating a part of a lithium-ion battery module according to another embodiment.
[Fig. 9] Fig. 9 is a view schematically illustrating an entire lithium-ion battery module.

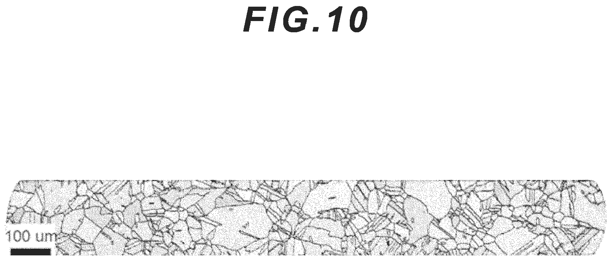

[Fig. 10] Fig. 10 is a view illustrating a cross section in a direction perpendicular to the longitudinal direction of a copper bonding ribbon according to an embodiment in which the ratio of the coincidence site lattice boundary length is measured by EBSD.

### Description of Embodiments

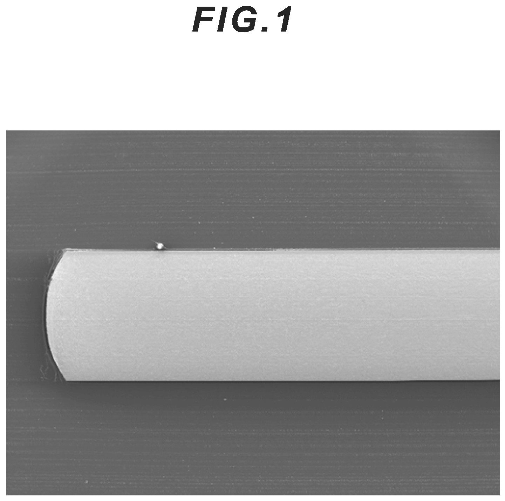

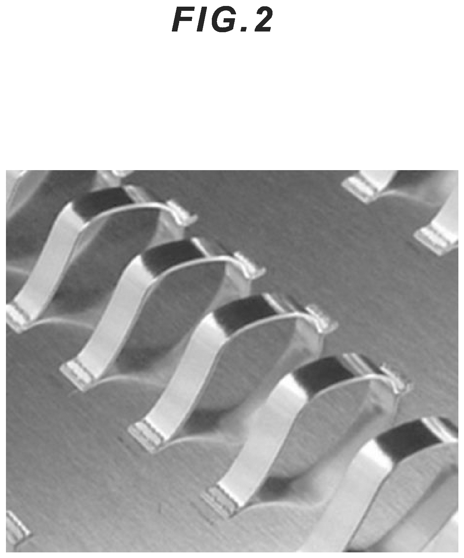

Hereinafter, a copper bonding ribbon according to an embodiment of the present invention will be described. Figs. 1 and 2 are photographs showing a copper bonding ribbon according to the present embodiment. Fig. 1 is a photograph showing a part of a cross section in a direction perpendicular to the longitudinal direction of the copper bonding ribbon. Fig. 2 is an oblique overhead view photograph of the copper bonding ribbon. The copper ribbon according to the present embodiment comprises a copper alloy having a copper purity of 99.99 mass % or more, and contains, relative to the total amount, 5 mass ppm or more and 40 mass ppm or less of silver (Ag), and 0 mass ppm or more and 10 mass ppm or less of phosphorus (P). The copper ribbon according to the present embodiment further contains one or more types selected from the group consisting of iron (Fe), silicon (Si), arsenic (As), and antimony (Sb) each in an amount of 0 mass ppm or more and 8 mass ppm or less, with a total content of phosphorus (P), iron (Fe), silicon (Si), arsenic (As), and antimony (Sb) being 0 mass ppm or more and 30 mass ppm or less. In the copper ribbon according to the embodiment, in a cross section perpendicular to a longitudinal direction of the copper bonding ribbon, the ratio of the coincidence site lattice boundary length to the total length of the crystal grain boundaries is 30% or more and less than 60%. Further, in the surface of the copper ribbon according to the embodiment, (1) an arithmetic average roughness (Ra) in the longitudinal direction is 30 nm or more and 150 nm or less, (2) an arithmetic average roughness (Ra) in a direction perpendicular to the longitudinal direction is 30 nm or more and 150 nm or less, and a value obtained by dividing (1) the arithmetic average roughness (Ra) in the longitudinal direction by (2) the arithmetic average roughness (Ra) in the direction perpendicular to the longitudinal direction is 0.75 or more and 1.15 or less. In this specification, unless otherwise specified, the arithmetic average roughness (Ra) is simply referred to as an "average roughness".

The coincidence site lattice boundary is a lowenergy grain boundary, and exists from Σ1 to Σ49 in the facecentered cubic crystal. The coincidence site lattice boundary length in the present embodiment is a value of the coincidence site lattice boundary of Σ3 among the above-mentioned coincidence site lattice boundaries.

The shape of the copper ribbon mainly depends on the method for manufacturing the copper ribbon. The methods for manufacturing the copper ribbon are classified into mainly two types. One is a method including producing a plate-shaped ingot in a melt casting process, rolling the ingot to a target thickness to draw it in the longitudinal direction, and finally cutting the end face vertically (slit processing). The other is a method including producing a cylindrical ingot in a melt casting process, performing continuous casting on the ingot, then repeating wire drawing to produce a wire with a certain thin wire diameter, and finally, rolling the wire to draw it in the longitudinal direction, thereby achieving the target thickness of the copper ribbon. Thin and long flat copper ribbons are produced by these methods. A top surface when the copper ribbon is placed flat (or the opposite surface) is defined as a copper ribbon plane, a direction parallel to the copper ribbon plane and perpendicular to the longitudinal direction of the copper ribbon is defined as a width of the copper ribbon, and the vicinities of both ends of the width are defined as the end surfaces of the copper ribbon. The end surfaces of the copper ribbon manufactured by the slit processing method become perpendicular to the plane of the copper ribbon. Since the end surface of a copper ribbon that has been produced by the latter manufacturing method, which involves rolling after wire drawing, is not cut at the final stage, the shape of the end surface is an arc or an elliptical shape (hereinafter, they are collectively referred to as "circular arcs"). This region having a curvature is defined as the end surface. Although there may be rare copper ribbons in which the end surface is square cut through a die after slit processing, these copper ribbons are also included in the copper ribbons having a curvature.

Hereinafter, the details of the development process that had taken place until the present invention has been completed, and the configuration and manufacturing method of the copper ribbon according to the present embodiment will be described in detail.

### (Extended Service Life of Cutter)

When the load on the cutter during cutting the copper ribbon is large, the sharpness of the cutter that is used to cut the copper ribbon deteriorates at an early stage and the frequent replacement of the cutter is needed. Needless to say, the cost of the cutter increases, and as the frequency of replacement of the cutter increases, the number of times the bonding machine stops increases, consequently decreasing the productivity in the bonding process.

The cutter used in the present embodiment is, for example, Kulicke & Soffa's front cutter 01-25028, size part number 13 (or size part number 33). The dimensions of the cutter are: total length of about 20 mm; width of about 3 mm; thickness of about 1 mm; length of the cutting edge part of about 2.5 mm; length of the part other than the cutting edge part (attachment part) of about 17.5 mm; width of the cutting edge tip of about 2.2 mm; and thickness of about 0.05 mm.

First, in order to consider a method for cutting a copper ribbon without applying a load on the cutter, the present inventors carefully investigated many prototypes manufactured under various manufacturing conditions. As a result, they have noticed that there is a correlation between the metal structure in the longitudinal direction, that is, in the cross section perpendicular to the rolling direction of the copper ribbon, that is, the ratio of coincidence site lattice boundaries (special grain boundaries) to the total grain boundary length, and the load applied to the cutter. Hereinafter, the cross section perpendicular to the longitudinal direction of the copper ribbon is also referred to as a "transverse section".

The coincidence site lattice boundary is a grain boundary structure that, despite being located in a crystal grain boundary position, has an atomic arrangement that is more regular and has significantly fewer disarrangements and gaps than a normal grain boundary because the atoms are situated at crystal lattice positions. That is, the grain boundary is robust to the extent that the gaps therein are small. However, such robustness imposes a significant load on a cutter during cutting. Accordingly, the present inventors had surmised that the service life of the cutter can be extended by controlling the ratio of the coincidence site lattice boundary length to be small.

The coincidence site lattice boundary length can be measured by electron backscattered diffraction (EBSD). The present inventors have investigated the relationship between the ratio of the coincidence site lattice boundary length to the total grain boundary length and the service life of the cutter. As a result, the inventors have discovered that the ratio of the coincidence site lattice boundary length set to less than 60% relative to the total grain boundary length prevents the service life of the cutter from being shortened.

However, an excessively small ratio of the coincidence site lattice boundary length increases the risk of impairing the oxidation resistance of the copper ribbon. While oxidation resistance also relates to the elements contained in the product of the present invention, which will be described later; however, the present inventors conducted exposure tests on a plurality of copper ribbons having different ratios of the coincidence site lattice boundary length to investigate the correlation between the ratio of the coincidence site lattice boundary length and the oxidation resistance. As a result, the inventors have discovered that the ratio of the coincidence site lattice boundary length of 30% or more yields a product of the present invention with superior oxidation resistance, specifically, characterized by the ratio of a copper(II) oxide (CuO) film on the surface of the copper ribbon after a six-month exposure test being 30% or less. Accordingly, the inventors have found that a suitable ratio of the coincidence site lattice boundary length is in a range of 30% or more and less than 60% with respect to the total length of the grain boundaries. Furthermore, the ratio of the coincidence site lattice boundary length is preferably 33% or more and less than 55%, and more preferably 35% or more and less than 50%.

As described above, by setting the ratio of the coincidence site lattice boundary length to less than 60%, an improvement in the cutter service life of about 10% was obtained. With the aim of further extending the cutter service life, the present inventors focused on the shape of the copper ribbon and conducted intensive research. As a result, the inventors have discovered that there is a correlation between the end face shape of the copper ribbon and the cutter service life.

As described above, the end face shape of the copper ribbon depends on the manufacturing method of the copper ribbon. The end face of a copper ribbon manufactured by a slit processing method is perpendicular to the plane of the copper ribbon. In a copper ribbon manufactured by a method of rolling after wire drawing, the end face shape becomes an arc shape because the end face is not cut at the final stage.

The present inventors repeatedly conducted experiments to confirm which shape, between a straight end face and an arc-shaped end face of a copper ribbon is effective in extending the service life of the cutter. As a result, the inventors have found that the copper ribbon having an arc-shaped end face was more effective in extending the service life of a cutter.

Furthermore, the present inventors focused on the radius of curvature of the arc of the end face. Noticing that the radius of curvature varied depending on the thickness of the copper ribbon, the present inventors compared a value obtained by dividing the radius of curvature of the end face of the copper ribbon by the thickness of the copper ribbon with the service life of a cutter, and evaluated the correlation therebetween. As a result, the inventors have found that a copper ribbon, in which the value obtained by dividing the radius of curvature by the thickness of the copper ribbon is 0.50 or more and 0.90 or less, was most effective in extending the service life of a cutter.

The reason for the correlation between the end face shape of the copper ribbon and the service life of a cutter is presumed as follows. When cutting a copper ribbon, it was rare for the edge of the cutting blade to come into perfectly parallel contact with the plane of the copper ribbon, and a slight angular difference occurs between the edge of the cutter blade and the plane of the copper ribbon. That is, the blade often touches the plane of the copper ribbon at a slight angle. This increases the likelihood that the cutting blade will strike the end face of the copper ribbon (particularly, the boundary between the rolled plane and the end face). In this case, if the end face is perpendicular to the rolled plane (the plane of the copper ribbon), the initial contact of the cutter hits a sharp portion (the right-angled portion), thereby causing considerable damage to the cutter. On the other hand, if the end face is arc-shaped, the initial contact is softer than at a right-angled portion, which is presumed to have eventually led to extending the service life of the cutter.

The present inventors manufactured many prototypes by changing the reduction ratio (working ratio) of the drawn wire during roll rolling, and found a radius of curvature effective for the service life of the cutter among copper ribbons of different dimensions. Then, the inventors have found that a copper ribbon, in which a value obtained by dividing the radius of curvature of the end face of the copper ribbon by the thickness of the copper ribbon is 0.90 or less, is effective for improving the service life of a cutter, while the effect is not obtained when the value exceeds 0.90. Furthermore, a value of less than 0.50 does not affect the service life of a cutter, but may cause cracks on the end face of the copper ribbon or warpage of the copper ribbon itself. From these facts, the inventors have found that an optimum range for the value obtained by dividing the radius of curvature of the end face of the copper ribbon by the thickness of the copper ribbon is 0.50 or more and 0.90 or less. In addition, the value obtained by dividing the radius of curvature of the end face of the copper ribbon by the thickness of the copper ribbon is preferably 0.58 or more and 0.82 or less, and more preferably 0.66 or more and 0.74 or less.

The radius of curvature of the copper ribbon can be measured as follows. After manufacturing the copper ribbon, the radius of curvature is measured at the approximate front end, rear end, and a midpoint part of a copper ribbon wound on a spool with a length of, for example, 100 m. Specifically, it is preferable to measure the radii of curvature at both widthwise ends of a copper ribbon at these three locations, obtain a total of six measured values, and calculate an average value thereof. Samples are collected by cutting out a portion of the copper ribbon at three locations: the front end, the rear end, and the midpoint portion thereof. The collected samples are embedded in a resin and polished to expose a cross section perpendicular to the longitudinal direction. As a result, the cross section perpendicular to the longitudinal direction was exposed. The radius of curvature of the end face of the copper ribbon was determined on the exposed cross section by automatic calculation using an image analyzer (for example, WinROOF, manufactured by Mitani Corporation) by specifying three points: an inflection point between the plane (rolled surface) of the copper ribbon and the end face; an outermost point of the end face; and an inflection point between the plane (rolled surface) on the side (back surface) opposite to the plane (rolled surface) of the copper ribbon and the end face.

### (Chip Damage)

Next, a description will be given of a method for reducing damage during bonding when the bonding target for the copper ribbon is a delicate object, such as an IC chip, which is vulnerable to external loads and is easily damaged. Since copper is extremely hard compared to gold, silver, and aluminum conventionally used for bonding wires, softening the copper ribbon is a basic countermeasure, and a challenge is how to obtain sufficient bond strength with a low load.

The present inventors surmised that, in addition to softening the copper ribbon, if the bonding area is increased, the bond strength can be increased even with a low load. Although attempts have been made so far to increase the bonding area by roughening the surface of the copper ribbon, most of these attempts involved roughening only in one direction, such as the direction perpendicular to the longitudinal direction, or chemically roughening with a chemical agent.

For example, if scratches (patterns) are formed such that irregularities of a rolling roll are transferred to the surface of the copper ribbon only in the longitudinal direction of the plane of the copper ribbon, irregularities in the direction perpendicular to the longitudinal direction are formed, but irregularities are hardly formed in the longitudinal direction. These irregularities have a sawtooth shape with sharp peaks, and the interval between a peak (convexity) and a valley (concavity) tends to be short. Therefore, during bonding of the copper ribbon, the peaks are hard to collapse, and contact between the tops of the peaks and the bonding counterpart results in point contact, thus, the bonding area becomes small, and an increase in bond strength cannot be expected.

The method of roughening a material by chemically dissolving it with a chemical agent involves incurring costs for using the chemical agent, and furthermore, there is a possibility that the material may be contaminated by the chemical agent.

The present inventors surmised that, without using a chemical agent, by forming a rectangular-shaped surface having equivalent irregularities in the longitudinal direction and in a direction perpendicular to the longitudinal direction, and having a wide interval between peaks and valleys, it would be possible to obtain a high bond strength with a low load without damaging bonding targets even if such bonding targets are delicate. In the case of the rectangular-shaped surface, the present inventors surmised that the load on the bonding target could be reduced because it would have cushioning properties compared to a sawtooth-shaped surface.

Based on these ideas, the present inventors produced, with various manufacturing methods, copper ribbon prototypes having different surface roughness values of the copper ribbon, and conducted intensive research into what kind of surface roughness would allow a high bond strength to be obtained with a low load. As a result, the inventors have discovered that a range in which a high bond strength is obtained with a low load is where (1) the average roughness of the plane of the copper ribbon in the longitudinal direction and (2) the average roughness in the direction perpendicular to the longitudinal direction are both 30 nm or more and 150 nm or less, and a value obtained by dividing (1) the average roughness in the longitudinal direction by (2) the average roughness in the direction perpendicular to the longitudinal direction is 0.75 or more and 1.15 or less. When the values of (1) the average roughness in the longitudinal direction and (2) the average roughness in the direction perpendicular to the longitudinal direction are less than 30 nm or exceed 150 nm, the bond strength decreases. When the value obtained by dividing (1) the average roughness in the longitudinal direction by (2) the average roughness in the direction perpendicular to the longitudinal direction is less than 0.75 or more than 1.15, the possibility of damaging the bonding object increases. Both (1) the average roughness in the longitudinal direction and (2) the average roughness in the direction perpendicular to the longitudinal direction are preferably 55 nm or more and 130 nm or less, and more preferably 60 nm or more and 120 nm or less. The value obtained by dividing (1) the average roughness in the longitudinal direction by (2) the average roughness in the direction perpendicular to the longitudinal direction is preferably 0.80 or more, and more preferably 0.85 or more.

### (Problems of Oxide Generation and Electrical Conductivity)

Next, the composition of the copper ribbon of the present embodiment will be described. As described above, the copper ribbon has a larger bonding area (volume) than a copper wire. For example, when comparing a copper wire that is to be used in a power device and has a wire diameter of 200 µm with a copper ribbon that has a thickness of 200 µm and a width of 1250 µm, the thickness being the same as the wire diameter of the copper wire, the volume of the copper ribbon is about 8 times larger than that of the copper wire when the lengths are the same, and the bonding area is similarly larger. As described above, since the area of the bonding portion of the copper ribbon is larger than that of the copper wire, the bonding force is also enhanced. Furthermore, since the bonding area of the copper ribbon is larger than that of the copper wire, the number of bonds can be smaller than that of the copper wire to pass an equivalent current, and the number of bonding times is reduced, significantly contributing to productivity.

However, the copper surface is relatively easy to oxidize. In bonding copper wires, pressure is applied from the wire radial direction by a tool at the bonding portion, and the wires are bonded (pressure-bonded) while being plastically deformed. Therefore, even if the wire surface is oxidized, sufficient bond strength can be obtained because unoxidized copper inside is exposed during plastic deformation.

On the other hand, since the copper ribbon has a flat shape, large plastic deformation does not occur during bonding. This result is different from that with copper wires, which are formed into a flat shape during bonding. Therefore, the exposure of unoxidized copper inside the ribbon during plastic deformation is extremely small compared to wire bonding. Accordingly, oxidation of the copper ribbon surface has a greater influence on bond strength than oxidation of the copper wire surface, posing a serious problem. In addition, unlike ball bonding, the copper ribbon is bonded at room temperature, and thus, surface oxidation of the copper ribbon has an even more significant adverse effect on bond strength.

Furthermore, the copper ribbon surface becomes considerably hard because of the progress of oxide generation, which may adversely affect the service life of the cutter blade. In addition, if the bonding target for the copper ribbon is a delicate one such as an IC chip, the copper ribbon having an oxide generated on its surface increases the possibility of damage due to the hardness of the copper ribbon being done to the IC chip.

As described above, since the copper ribbon has a larger bonding area (volume) than the copper wire, a large amount of current can flow at a time. However, if the electrical resistance of the copper ribbon itself is high, loss due to resistance increases. Therefore, in order to reduce loss due to resistance, the present inventors intended to ensure an electrical conductivity of at least 99 % or more for the copper ribbon (purity: 99.99 mass %) of the present embodiment, relative to the electrical conductivity, as 100%, of ultra-high purity copper (purity: 99.999 mass %) having significantly fewer impurities than that of the copper ribbon.

As described above, the popularization of electric vehicles is expected as a countermeasure against global warming (reduction of carbon dioxide emissions). However, a problem with the popularization of electric vehicles is that the length of the traveling distance (cruising range) of the electric vehicle on a full charge is shorter than that of a gasoline vehicle. In order to extend the traveling distance of electric vehicles, downsizing (weight reduction) of the vehicle is effective. However, if the energy loss during switching (on/off) in the power semiconductor is large, the heat release also becomes large, so a large cooling space is required to cool the power semiconductor. This cooling space hinders the downsizing of electric vehicles. Since energy loss increases when electrical resistance is high, the reduction of electrical resistance in the power semiconductor is an important key to the popularization of electric vehicles.

Here, even when the bondable space in the semiconductor device is small, bonding of the copper wire is possible by providing sufficient followability and flexibility to the copper wire in addition to the contribution of the small cross-sectional area of the wire. Therefore, even if the electrical resistance of the copper wire is relatively high, the loss due to electrical resistance can be compensated by increasing the number of bonds of the copper wire.

On the other hand, in general, since the cross-sectional area of the copper ribbon is larger than that of the copper wire, the followability by which the shape of the copper wire follows the tool during bonding is poorer than that of the copper wire. That is, since the followability and flexibility of the copper ribbon are low, it is difficult to apply the copper ribbon to bonding other than unidirectional and linear bonding, for example, bonding that undergoes abrupt bending or twisting. Therefore, it is difficult to increase the number of bonds of the copper ribbon, and if the electrical resistance becomes high, it directly leads to energy loss. As described above, high electrical conductivity of the copper ribbon itself is a very important condition.

The inventors studied the composition of a copper alloy constituting a copper ribbon in order to simultaneously solve the problem of oxide generation on the copper ribbon surface and the problem of electrical conductivity. The inventors searched for a trace element that effectively suppresses the progress of generation of copper oxide as a base material and suppresses an increase in electrical resistance. As a result of conducting intensive experiments by adding numerous kinds of elements to the copper base material, the inventors have discovered that making the purity of copper 99.99 mass % or more, adding silver (Ag) as a trace element, and controlling the contents of phosphorus (P), iron (Fe), silicon (Si), arsenic (As), and antimony (Sb) have the effect of suppressing the generation of copper oxide and the increase in electrical resistance.

As a result of conducting many experiments, the inventors have discovered that, relative to the total amount of the copper alloy, the content of silver (Ag) is preferably 5 mass ppm or more and 40 mass ppm or less, phosphorus (P) is preferably contained in an amount of 0 mass ppm or more and 10 mass ppm or less, the content of each element of iron (Fe), silicon (Si), arsenic (As), and antimony (Sb) is preferably 0 mass ppm or more and 8 mass ppm or less, and the total amount of phosphorus (P), iron (Fe), silicon (Si), arsenic (As), and antimony (Sb) is preferably 0 mass ppm or more and 30 mass ppm or less relative to the entire copper ribbon, from the viewpoint of suppressing the generation of surface oxide and maintaining the electric conductivity.

The inventors have discovered that, when the content of silver (Ag) is 5 mass ppm or more and 40 mass ppm or less, and at the same time, when the content of phosphorus (P) is 0 mass ppm or more and 10 mass ppm or less, the content of each element of iron (Fe), silicon (Si), arsenic (As), and antimony (Sb) is 0 mass ppm or more and 8 mass ppm or less, and the total of the above trace elements excluding silver (Ag) is 0 mass ppm or more and 30 mass ppm or less, the effect of delaying the generation of copper oxide is easily obtained and the electric resistance of the entire copper ribbon does not increase excessively.

In particular, in the manufacturing process of the copper ribbon of the present embodiment, when the copper ribbon is exposed to a high temperature during heat treatment, the generation rate of copper oxide is accelerated, although this effect depends on the heat treatment atmosphere. In this case, by controlling the composition of the copper ribbon of the present embodiment and controlling the ratio of the coincidence site lattice boundary length to 30% or more, an effect of reducing the generation rate of copper oxide on the copper ribbon surface during heat treatment is exhibited.

The susceptibility of the copper ribbon surface to oxidation can be evaluated by measuring an oxide film of copper(II) oxide (CuO) generated on the copper ribbon surface after an exposure test. In the exposure test, a copper ribbon sample is accommodated in an unsealed container or the like and left at a room temperature of 35°C and a humidity of 75%RH. Under these conditions, the sample is left for a maximum of 10 months, and during that time the CuO oxide film generated on the copper ribbon surface is measured at the beginning of the exposure test (after 1 hour) and every month, such as after 1 month, 2 months, and 3 months, until 10 months. In the progression process of copper oxidation, copper(I) oxide (Cu₂O) is generated first, and the ratio of CuO increases as oxidation progresses. Therefore, the susceptibility of the copper ribbon surface to oxidation can be evaluated by calculating the ratio of the CuO oxide film. The degree of oxidation progress can be expressed by the following equation: 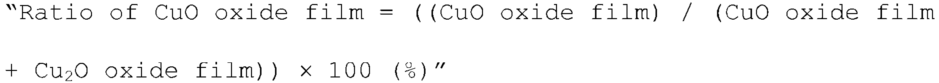 "Ratio of CuO oxide film = ((CuO oxide film) / (CuO oxide film + Cu2O oxide film)) × 100 (%)"

In the present embodiment, in particular, the ratio of the CuO oxide film after 6 months is regarded as an evaluation standard, and if the ratio of the oxide film of copper(II) oxide (CuO) is 30% or less, it is evaluated as pass "B" in the sense of being at a minimum level or higher. If the ratio of the oxide film of copper(II) oxide (CuO) is 25% or less, it is evaluated as "A" in the sense of being good. If the ratio of the oxide film of copper(II) oxide (CuO) is 20% or less, it is evaluated as "S" in the sense of being better. The analytical method will be described later.

IACS (International Annealed Copper Standard) was adopted for the evaluation of electrical conductivity. Compared with the IACS value (100%) of copper with a purity of 99.999 mass % at room temperature (20°C), a sample showing a decrease in IACS value of less than 0.5% was rated as "S" in the sense of being excellent. Compared with the IACS value (100%) of copper with a purity of 99.999 mass % at room temperature (20°C), a sample showing a decrease in IACS value of 0.5% or more and less than 0.8% was rated as "A" in the sense of being good. In addition, compared with the IACS value (100%) of copper with a purity of 99.999 mass % at room temperature (20°C), a sample showing a decrease in IACS value of 0.8% or more and less than 1.0% was rated as "B" in the sense that it is at or above the minimum level for practical use. Compared with the IACS value (100%) of copper with a purity of 99.999 mass % at room temperature (20°C), a sample showing a decrease in IACS value of 1.0% or more was rated as "F" in the sense that there is a high possibility that a defect will occur in practical use. Details of the measurement method regarding the IACS will be described later.

The dimensions of the copper ribbon of the present embodiment are, for example, preferably a width of 0.3 mm or more and 5.0 mm or less and a thickness of 0.05 mm or more and 0.5 mm or less, and more preferably a width of 1.0 mm or more and 3.0 mm or less and a thickness of 0.1 mm or more and 1.0 mm or less. Note that the width of the copper ribbon is the maximum distance from the apex of one end face (the outermost point) to the apex of the other opposite end face, and the thickness of the copper ribbon is the maximum distance between the plane of the copper ribbon and the opposite surface.

(Method for Manufacturing Copper Ribbon) Next, an example of a method for manufacturing the copper ribbon of the embodiment will be described. Note that the method for manufacturing the copper ribbon is not limited to the manufacturing method described below. In addition, it is desirable to appropriately adjust the conditions in view of the weight of the copper ribbon to be manufactured and the processing capacity of the heat treatment furnace. As described above, the copper ribbon of the present embodiment employs a process of manufacturing a copper wire having a relatively small wire diameter and then rolling the copper wire to finish it into a copper ribbon.

First, silver is dissolved in high-purity copper of 99.99 mass % or more in accordance with the composition of the obtained copper ribbon to produce molten copper. For melting, a heating furnace such as an arc heating furnace, a highfrequency heating furnace, a resistance heating furnace, or a continuous casting furnace is used. Although melting in the atmosphere is not a problem, it is desirable to melt the molten copper in a heating furnace while keeping it in a vacuum or an inert gas atmosphere such as argon or nitrogen in order to prevent mixing of air from the atmosphere. The molten material is solidified by continuous casting it from the heating furnace to have a predetermined wire diameter (diameter) to produce a bare wire. Alternatively, a cylindrical ingot may be produced by casting molten copper into a mold, and the ingot may be extruded by an extruder in a manner that forms a predetermined wire diameter to produce a bare wire. In addition, a rough-drawn wire may be manufactured by a DIP forming method or an SCR method and used as a bare wire.

The bare wire obtained in the above process is subjected to wire drawing to form an intermediate wire material having a wire diameter of 900 µm. Then, the intermediate wire is subjected to an intermediate heat treatment in which heating is performed at 400°C to 600°C for 60 minutes to 420 minutes. For the intermediate heat treatment, a "combustion furnace" using oil, gas, or the like as a heat source or an "electric furnace" using electric energy as a heat source may be used. The intermediate heat treatment may be a "batch type" or a "continuous type (tubular furnace type)." It may also be an "direct resistance heating type" in which the wire is heated by direct energization. The heat treatment atmosphere is preferably an inert gas atmosphere from the viewpoint of preventing oxidation of the wire.

Next, the wire after the intermediate heat treatment is drawn to a target final wire diameter. The final wire diameter of the wire can be determined by taking into account the width and thickness of the target copper ribbon and the radius of curvature of the end face. For example, in order to manufacture a copper ribbon having a width of 1.25 mm, a thickness of 0.2 mm, and a radius of curvature of 180 µm, the copper wire is preferably drawn to a wire diameter of 700 µm. In the wire drawing, the wire diameter can be reduced step by step by passing the wire through a plurality of carbide dies or diamond dies in order. The wire reduction ratio (also referred to as the area reduction ratio or the working ratio) before and after one die drawing is preferably 5% or more and 30% or less.

The copper wire drawn to the final wire diameter is rolled to the target dimensions of the copper ribbon (width, thickness, and radius of curvature) by a two-high roll by a rolling mill. Depending on the dimensions of the copper ribbon, the copper wire is preferably rolled several times by the two-high roll. The area reduction ratio of the cross-sectional area when the wire is processed into the ribbon shape is preferably 3% or more and 15% or less. The area reduction ratio (rolling reduction) of the cross-sectional area when the ribbon shape is processed into another ribbon shape is preferably 10% or more and 60% or less.

As the final process, the ribbon that has been processed to have the final dimensions is subjected to heat treatment (final heat treatment). In this step, the final heat treatment conditions are the most important for manufacturing the copper ribbon of the embodiment. As a result of the trial and error through various heat treatment experiments, the present inventors have found that the following method is most preferable as the manufacturing process for the copper ribbon of the embodiment. For the final heat treatment, a direct resistance heating method was adopted. As conditions for the direct resistance heating, a voltage value of 18 V or more and 24 V or less, a distance between electrode terminals of 900 mm or more and 1300 mm or less, and a ribbon traveling speed of 70 m/min or more and 150 m/min or less are set, and a second electrode was immersed in cooling water (by this configuration, the ribbon moves into the cooling water while being heated). Deionized water is used as the cooling liquid, and the temperature of the deionized water is preferably 30°C or higher and 60°C or lower, and the dissolved oxygen concentration in the deionized water is preferably 7 mg/liter or less. Note that, in order to prevent oxidation of the copper ribbon, the space between the electrode terminals through which the copper ribbon passes is preferably covered in a tubular shape, and nitrogen gas is preferably caused to flow at a flow rate of, for example, 30 liters/minute or more and 50 liters/minute or less. Although the direct resistance heating method has been described here, other heat treatment methods may be adopted to realize the surface roughness, the ratio of the coincidence site lattice boundary length (also referred to as a coincidence site lattice boundary density), and the like of the copper ribbon of the embodiment described above.

Previously, the surface roughness of the ribbon often depended on the irregularities of the surface of rollers used in rolling. That is, a manufacturing method for controlling the surface roughness by providing irregularities to the rollers according to the target roughness and transferring the irregularities to the material to be rolled has often been adopted. However, with these conventional manufacturing methods, a large difference may occur in the average roughness in the longitudinal direction and the direction perpendicular to the longitudinal direction. As described above, this microscopically results in a saw-tooth surface state, which makes sharp contact with the bonding target. Therefore, there is a possibility of damaging the bonding target when the bonding target is a delicate IC chip or the like.

The method for controlling the surface roughness of the copper ribbon of the present embodiment is different from conventional methods. That is, in the method for controlling the surface roughness of the copper ribbon of the present embodiment, the roughness of the copper ribbon surface is not controlled by a physical or mechanical method, but the irregularities of the copper ribbon surface is controlled by promoting the growth of crystal grains inside the copper ribbon through optimal heat treatment and by utilizing the phenomenon that the crystal grains grown on the surface of the ribbon emerge. Unlike the irregularities formed physically or mechanically, since the irregularities are formed by the natural growth of crystal grains under the influence of the heat treatment temperature, it is presumed that the surface property is stabilized and the adhesion effect is improved.

In the method for manufacturing the copper ribbon of the present embodiment, it is possible to reduce the deviation of the surface roughness of the copper ribbon in a predetermined one direction. That is, the roughness is at the same level in both (1) the longitudinal direction and (2) the direction perpendicular to the longitudinal direction. Ideally, the closer the value obtained by dividing (1) the average roughness in the longitudinal direction by the average roughness in the direction perpendicular to the longitudinal direction approaches 1, the better. This is because the irregularities become bowl-shaped when viewed microscopically, and the bonding area to the bonding target is expanded, so that not only the bond strength is increased, but also the load during bonding is reduced. Thus, the bonding target is less likely to be damaged.

The present inventors have found that, in order to achieve the surface shape of the copper ribbon as described above, the conditions of the final heat treatment described above are important, and in particular, the heat treatment by a direct resistance heating method is most suitable.

### (Semiconductor Device)

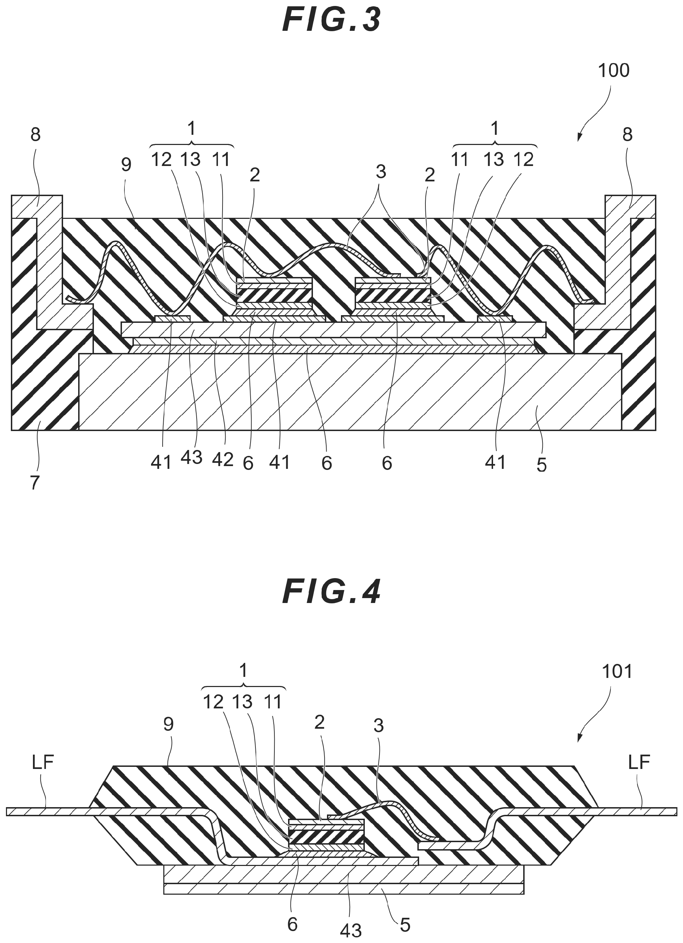

Next, a configuration of a semiconductor device 100 using the copper ribbon of the embodiment will be described with reference to Fig. 3.

As illustrated in Fig. 3, the semiconductor device 100 includes semiconductor elements 1, metal films 2, a ribbon 3, circuit patterns 41, a metal pattern 42, an insulating member 43, a heat dissipating member 5, bonding materials 6, a case 7, terminals 8, and a sealing material 9.

In the present embodiment, the semiconductor element 1 is, for example, a power semiconductor used as a semiconductor for power supply. As the semiconductor element 1, for example, a metal oxide semiconductor field effect transistor (MOSFET; Metal Oxide Semiconductor Field Effect Transistor), an insulated gate bipolar transistor (IGBT; Insulated Gate Bipolar Transistor), or the like may be mentioned.

The semiconductor element 1 is formed by stacking an electrode 11, a substrate portion 13, and a back surface electrode 12 in this order. The electrode 11 is, for example, an aluminum (Al) -silicon (Si) electrode, and the substrate portion 13 is, for example, a silicon (Si) substrate, a silicon carbide (SiC) substrate, a gallium nitride (GaN) substrate, or the like.

The metal film 2 is provided on the surface of the electrode 11 opposite to the substrate portion 13 so as to cover the surface of the electrode 11. The metal film 2 is a nickel (Ni) film, a copper (Cu) film, a titanium (Ti) film, a tungsten (W) film or the like, and is a film formed by electroplating, electroless plating, vapor deposition, sputtering, or the like. As the nickel (Ni) film, a nickel (Ni) electroless plating film may be mentioned, and specifically, an electroless nickel (Ni) - phosphorus (P) plating film, an electroless nickel (Ni) - boron (B) plating film, or the like may be mentioned. Other preferred embodiments of the metal film 2 will be described later.

The ribbon 3 is made of the copper ribbon of the embodiment described above, and the configuration and characteristics thereof are as described above. The ribbon 3 is bonded to the surface of the metal film 2.

Next, another configuration of the semiconductor device 100 will be described. In the semiconductor device 100, a semiconductor circuit is formed by the semiconductor element 1, the ribbon 3, the terminals 8, the circuit patterns 41, and the metal pattern 42. The ribbon 3 is bent in the semiconductor device 100, and is bonded to the semiconductor elements 1, the terminals 8, the circuit patterns 41, and the like at the bent portions.

In the semiconductor device 100, the bonding materials 6, the metal pattern 42, the insulating member 43, the circuit patterns 41, the bonding materials 6, and the semiconductor element 1 are sequentially stacked on the surface of the heat dissipation member 5. The bonding material 6 is made of a solder, silver (Ag), or the like for bonding the heat dissipation member 5 and the metal pattern 42, and the circuit pattern 41 and the back surface electrode 12 of the semiconductor element 1, respectively. The insulating member 43 is an insulating substrate or the like.

The case 7 is formed of an annular housing having a space therein, and is provided so as to surround the outer periphery of the heat dissipation member 5. The semiconductor elements 1, the metal films 2, the ribbon 3, the circuit patterns 41, the metal pattern 42, the insulating member 43, the bonding materials 6, and the sealing material 9 described above are accommodated in the internal space of the case 7.

The terminals 8 function as a connection terminal with an external device. The terminals 8 are provided on the upper surface of the case 7, and are each disposed such that one end portion thereof protrudes from the case 7 into the internal space of the case 7 and the other end portion thereof protrudes from the case 7 to the outside region of the case 7. The sealing material 9 is filled in the internal space of the case 7 so as to enclose the semiconductor elements 1, the metal films 2, the ribbon 3, the circuit patterns 41, the metal pattern 42, the insulating member 43, and the bonding materials 6. The sealing material 9 is a cured product of a gel-like sealing resin, a mold resin, or the like.

The semiconductor device 100 illustrated in Fig. 3 may include electrodes 11 on a plurality of semiconductor elements 1, a plurality of circuit patterns 41, and a plurality of terminals 8. The semiconductor device 100 preferably has an electrode-circuit pattern bonding structure including one electrode 11 out of the electrodes 11 on the semiconductor elements 1, one circuit pattern 41 out of the circuit patterns 41, and a wire 3 connecting the electrode 11 and the circuit pattern 41. The semiconductor device 100 preferably has an electrode-terminal connection structure including one terminal 8 out of the terminals 8, one electrode 11 out of the electrodes 11, and the wire 3 connecting the terminal 8 and the electrode 11. Furthermore, the semiconductor device 100 preferably has a circuit pattern-terminal connection structure including one terminal 8 out of the terminals 8, one circuit pattern 41 out of the circuit patterns 41, and the wire 3 connecting the terminal 8 and the circuit pattern 41. The semiconductor device 100 includes one or more electrode-circuit pattern bonding structures, one or more electrode-terminal connection structures, and one or more circuit pattern-terminal connection structures, and preferably includes two or more electrode-circuit pattern bonding structures, two or more electrode-terminal connection structures, and two or more circuit pattern-terminal connection structures. That is, the copper wire of the embodiment can be used for connection between the electrode 11 and the circuit pattern 41, for connection between the terminal 8 and the electrode 11, or for connection between the terminal 8 and the circuit pattern 41.

The semiconductor device 100 may further include a substrate (on-semiconductor-element substrate) on the semiconductor element 1, and in this case, the semiconductor device 100 preferably has a bonding structure including the on-semiconductor-element substrate, the circuit pattern 41, and a wire 3 connecting the on-semiconductor-element substrate and the circuit pattern 41. The same applies to semiconductor devices 101 and 103 described later.

Fig. 4 illustrates a semiconductor device 101 having a lead frame as another embodiment of the semiconductor device. In Fig. 4, the same reference numerals are used for configurations that exhibit the same functions as those of the semiconductor device 100 illustrated in Fig. 3, and a detailed description thereof is omitted. The semiconductor device 101 illustrated in Fig. 4 has a lead frame LF in addition to a semiconductor element 1, a metal film 2, a ribbon 3, an insulating member 43, a bonding material 6, and a sealing material 9. Since the semiconductor device 101 illustrated in Fig. 4 has the lead frame LF, it does not have a case 7, but it may be provided with the case 7. The lead frame LF is bonded on the surface of the insulating member 43 and has a function similar to that of the circuit pattern 41 of the semiconductor device 100 illustrated in Fig. 3. Note that, in Fig. 4, although the lead frame LF and the insulating member 43 are bonded, a metal plate (not illustrated) may be disposed between the lead frame LF and the insulating member 43.

The sealing member 9 is provided so as to enclose the semiconductor element 1, the metal film 2, the ribbon 3, the insulating member 43, the bonding member 6, and the lead frame LF. However, the end portion of the lead frame LF protrudes outside the sealing member 9, so that the lead frame LF constitutes an electric circuit with the semiconductor element 1 and the ribbon 3. The protruding end portion functions as a terminal 8 for connecting to an external device of the semiconductor device 101.

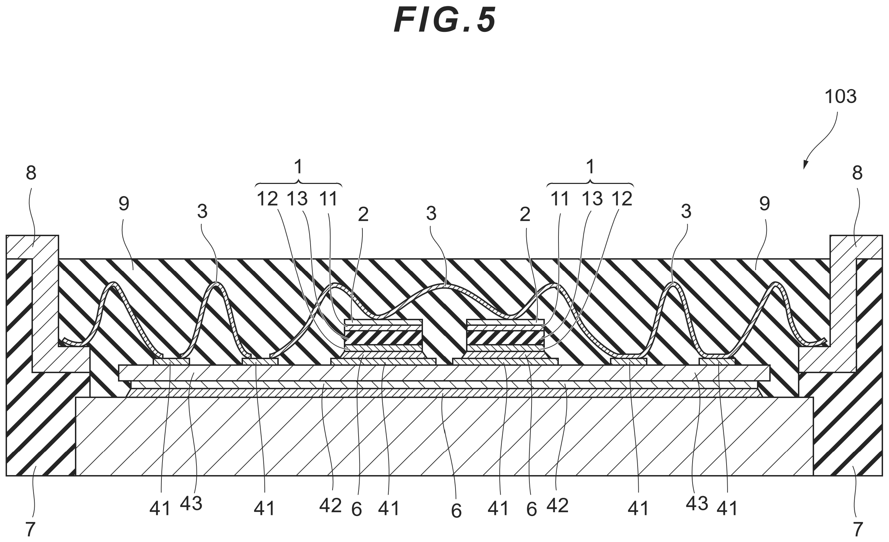

Fig. 5 schematically illustrates a semiconductor device 103 having a ribbon 3 that connects circuit patterns 41, as another embodiment of the semiconductor device. The semiconductor device 103 is different from the semiconductor device 100 illustrated in Fig. 3 in that it has another circuit pattern 41 adjacent to the circuit pattern 41 and that the ribbon 3 connects the adjacent circuit patterns 41 to each other, but other configurations are common. The semiconductor device 103 illustrated in Fig. 5 may have a plurality of circuit patterns 41, and includes a bonding structure including two adjacent circuit patterns out of the circuit patterns 41 and the ribbon 3 connecting the two adjacent circuit patterns to each other. The semiconductor device 103 includes one or more bonding structures, preferably two or more. That is, the copper ribbon of the embodiment can be used for connecting the circuit patterns 41 to each other.

Next, a method for manufacturing the semiconductor device 100, the semiconductor device 101, and the semiconductor device 103 illustrated in Figs. 3, 4, and 5 will be described. First, the respective members constituting the semiconductor devices 100, 101, and 103 are prepared, stacked as per the respective configurations described above, and bonded to each other. Then, an end of the ribbon 3 is bonded to the surface of the metal film 2 by ultrasonic bonding or the like. Thereafter, the other end of the ribbon 3 is wedge-bonded (second bond) to an external electrode (the terminal 8 of Figs. 3 and 4 or LF of Fig. 4). As the ribbon 3, the copper ribbon of the embodiment described above is used. Then, a sealing resin is injected into the semiconductor devices 100 and 103 and cured to form the sealing material 9. In the case of the semiconductor device 101, the lead frame on which the semiconductor element 1 and the like are mounted is placed in a mold, and the sealing resin is injected into the mold and thereafter cured to form the sealing material 9.

In the semiconductor device on which the copper ribbon of the above-described embodiment is mounted, since there is no chip damage at the ribbon bonding portion and the bond strength is maintained, the bonding of the bond portion 31 can be stably maintained for a long period of time. Furthermore, by extending the service life of a cutter, the consumption cost of the cutter can be reduced and the frequency of cutter replacement can be reduced, resulting in superior production efficiency. As a result, by using the copper ribbon of the embodiment, a semiconductor device having high production efficiency and long-term reliability can be manufactured.

### [Examples]

Examples will be described below. The present invention is not limited to the following examples.

The copper ribbons of Examples were prepared by the following method and conditions. Copper having a purity of 99.999 mass % or more and silver as an additive element were dissolved together. A continuous casting furnace (heating furnace) was used for the melting. In order to prevent contamination of oxygen or the like from the atmosphere, the molten copper in the heating furnace was melted while being held in a nitrogen atmosphere after being evacuated. The molten material was solidified from the heating furnace to a predetermined diameter by continuous casting, and a bare wire was thus produced.

The bare wire obtained above was drawn to a diameter of 0.9 mm, and an intermediate heat treatment was performed by heating the wire at 500°C for 120 minutes. The wire drawing was performed using a plurality of carbide dies or diamond dies so as to reduce the wire diameter step by step. The area reduction ratio before and after one wire drawing was in the range of 5 to 30%. Note that the final wire diameter was set to 580 µm in consideration of the target dimensions of the copper ribbon (width 1.25 mm, thickness 0.2 mm, radius of curvature of end face 180 µm).

The copper wire drawn to the final wire diameter was set in a rolling mill and rolled to the target dimensions of the copper ribbon by two-high rolls. The area reduction ratio of the cross-section when the wire was processed into the ribbon shape was set to 3% or more and 15% or less. In addition, the area reduction ratio of the cross-section per rolling when processing from a ribbon shape to a ribbon shape was set to 10% or more and 60% or less. The copper ribbons of Examples were rolled twice by two-high roll rolling, and the area reduction ratio of the cross-section in the first rolling was about 9% (from a wire diameter of 700 µm (0.7 mm) to a ribbon width of 1.0 mm × ribbon thickness of 0.35 mm), and the area reduction ratio of the cross-section in the second rolling was 28.6% (ribbon width of 1.25 mm × ribbon thickness of 0.20 mm).

The copper ribbon processed to the final dimensions was subjected to final heat treatment by an electric heating furnace. As conditions for the direct resistance heating, a voltage value of 18 V or more and 24 V or less, a distance between electrode terminals of 900 mm or more and 1300 mm or less, a travelling speed of the copper ribbon of 70 m/min or more and 150 m/min or less were set, and the second electrode was immersed in cooling water. Accordingly, the copper ribbon was immersed in cooling water while being heated. Deionized water was used as the cooling liquid, and direct resistance heating was performed at a deionized water temperature of 30°C or higher and 60°C or lower and a dissolved oxygen concentration in the deionized water of 7 mg/L or less. Note that the periphery of the electrode portion through which the copper ribbon passes was maintained in a nitrogen atmosphere. The conditions were changed within the above range, and samples of Examples 1 to 90 shown in Tables 1, 2, and 3 were obtained. After the final heat treatment, the copper ribbon was rewound onto a plurality of spools in units of about 100 m.

Table 4 shows the copper purity and some contained elements of the copper ribbons of Comparative Examples. The copper ribbons of Comparative Examples were manufactured under the same conditions as those of Examples except that some or all of the manufacturing conditions, such as the final wire diameter of the copper wire, the area reduction ratio in the rolling process, and the final heat treatment conditions (direct resistance heating conditions), were set outside the ranges of the conditions of Examples. Thus, the copper ribbons of Comparative Examples 1 to 33 were obtained.

However, in Example 37, Example 46, Comparative Example 15, and Comparative Example 25, the end faces were cut (slit processing) after the heat treatment to obtain ribbons with straight end faces, and then the obtained ribbons were rewound onto a spool.

Next, a method for measuring each characteristic of the copper ribbons of Examples and Comparative Examples will be described.

### (Measurement of Ratio of Coincidence Site Lattice Boundary Length)

The ratio of the coincidence site lattice boundary length (coincidence site lattice boundary density) of the cross section perpendicular to the longitudinal direction of the copper ribbon was measured as follows. The prepared copper ribbon was cut into several centimeter lengths, and several samples were prepared. The samples were adhered to a metal frame (metal plate) plated with Ag in a straight and flat manner, taking sufficient care not to deform the samples. Then, the samples together with the metal plate were put into a cylindrical mold so that the metal plate formed the bottom of the cylinder, and an embedding resin was poured into the mold. Thereafter, a curing agent was added to cure the resin. Next, the cured cylindrical resin containing the samples was subjected to rough polishing with a polisher so that a section perpendicular to the longitudinal direction of the copper ribbon was exposed. Then, the cut surface was finished by final polishing, and subsequently, residual strain of the polished surface was removed by ion milling to obtain a smooth surface. Note that the ion milling device was finely adjusted so that the cut surface of the copper ribbon was directed perpendicular to the longitudinal direction.

In the present embodiment, the coincidence site lattice boundary density was measured and calculated by electron backscattered diffraction (EBSD). Specifically, the ribbon sample was attached to a sample stage of a field emission scanning electron microscope (FE-SEM: Field Emission Scanning Electron Microscope) equipped with an EBSD measuring device (OIM Data Collection manufactured by EDAX/TSL) so that the transverse section (i.e., the polished surface of the sample) of the ribbon sample was parallel to the sample stage. The settings were such that: an acceleration voltage was 15 kV, an inclination angle was 70 degrees, a measurement point interval was 1.5 µm, and a magnification was 60 times; a boundary where an orientation difference between adjacent measurement points was more than 5° was regarded as a crystal grain boundary, and if two or more pixels were connected with an orientation difference of 5° or less, it was recognized as one crystal grain.

The coincidence site lattice boundary density (%) was calculated by dividing the total length of the coincidence site lattice boundaries (µm) by the total length of the crystal grain boundaries (µm). The value of Σ3 in EBSD was adopted for the coincidence site lattice boundaries. Note that the measurement points were selected at the periphery of the front end (the leading end in the longitudinal direction), the periphery of the rear end (the end opposite to the leading end in the longitudinal direction), and an midpoint part of the copper ribbon of about 100 m. The coincidence site lattice boundary density in the cross section perpendicular to the longitudinal direction was measured at these three points, and the average value from these values is shown in Table 1.

### (Arithmetic Average roughness (Ra) of Copper Ribbon Plane)

The average roughness of the plane of the copper ribbon in the longitudinal direction and the average roughness in the direction perpendicular to the longitudinal direction were measured using a surface roughness meter (a compact fine profile measuring machine, Model ET200, manufactured by Kosaka Laboratories). The main measurement conditions were a cut-off of 0.25 mm, a measurement needle moving speed of 0.05 mm/sec, and a needle load of 100 µN. In the same manner as described above, the periphery of the front end and the periphery of the rear end of the copper ribbon of about 100 m and the midpoint part thereof were selected, and the average roughness was measured at these three points. The average roughness in the direction perpendicular to the longitudinal direction was measured by moving the measurement needle on a straight line from a position 10% inside the copper ribbon width from an edge of the copper ribbon to a position 10% inside the opposite edge of the copper ribbon. For example, for a copper ribbon of 1.25 mm width, the average roughness was measured by moving the measurement needle for a distance of 1.0 mm in the direction perpendicular to the longitudinal direction. Next, as for the average roughness in the longitudinal direction, the measurement needle was moved to measure the average roughness at the same distance (1.0 mm) as measured in the direction perpendicular to the longitudinal direction, on three straight lines parallel to the rolling direction that respectively pass through a total of 3 points that divide the ribbon width into four equal parts (that is, the center of the ribbon and points located at 25% of the ribbon width from both ends of the ribbon). Furthermore, in the same manner as in the measurement of the average roughness in the direction perpendicular to the longitudinal direction, the average value of the measured values at a total of nine points, i.e., three points at the periphery of the front end of the copper ribbon, three points at the periphery of the rear end of the copper ribbon, and three points at the midpoint part between the front end and the rear end, was adopted.

### ((1) Average Roughness of Copper Ribbon Plane in Longitudinal Direction / (2) Average Roughness of Copper Ribbon Plane in Direction Perpendicular to Longitudinal Direction)

Using (1) the average roughness of the copper ribbon plane in the longitudinal direction and (2) the average roughness of the copper ribbon plane in the direction perpendicular to the longitudinal direction measured above, a value obtained by dividing (1) the average roughness in the longitudinal direction by (2) the average roughness in the direction perpendicular to the longitudinal direction, that is, a value of (1) average roughness in the longitudinal direction / (2) average roughness in the direction perpendicular to the longitudinal direction, was calculated, and is shown in Tables 1, 2, and 3.

### (Radius of Curvature of End Surface of Copper Ribbon)

The radius of curvature of the copper ribbon was measured approximately at the front end, the rear end, and the midpoint part of a 100 m copper ribbon wound in the same manner as described above. Specifically, the radius of curvature of both widthwise ends of the copper ribbon at these three points was measured to obtain a total of six measured values, and the average value thereof was calculated. The collected sample was embedded in a resin and polished to expose a cross section perpendicular to the longitudinal direction. As a result, the cross section perpendicular to the longitudinal direction was exposed. The radius of curvature of the end face of the copper ribbon was determined on the exposed cross section by automatic calculation using an image analyzer (WinROOF, manufactured by Mitani Corporation) by specifying three points: an inflection point between the plane (rolled surface) of the copper ribbon and the end face; an outermost point of the end face; and an inflection point between the plane (rolled surface) on the side (rear surface) opposite to the plane (rolled surface) of the copper ribbon and the end face.

Although the methods of measuring each characteristic of the copper ribbon in the Examples have been described above, the length of the sample of the copper ribbon for measuring each characteristic can be appropriately adjusted. For example, when the length of the copper ribbon is less than about 100 m, each characteristic of the copper ribbon may be measured by measuring each characteristic at the front end, the rear end, and a midpoint position between the front end and the rear end with respect to the length of the copper ribbon in the longitudinal direction.

In the EBSD measurement, it is preferable to perform measurement at a magnification such that the entire transverse section of the ribbon sample fits within the EBSD image. Since the copper ribbon in the Examples had dimensions of 1.25 mm in width and 0.2 mm in thickness, the magnification was set to 60 times so that the entire transverse section fitted within a single image. However, when a copper ribbon having larger dimensions than those in the Examples is measured by EBSD, the magnification is preferably set to be smaller than 60 times so that the entire transverse section can fit within a single image. For example, when the dimensions of the copper ribbon are 2.0 mm in width and 0.3 mm in thickness, the entire cross section fits within a single image if the magnification is set to 45 times. If the entire transverse section of the ribbon does not fit within a single image even after adjusting the measurement magnification, the entire transverse section is divided into a plurality of areas for measurement, and finally, the divided images of the transverse section are combined so that overlapping regions are minimized to create a single image, and each characteristic is calculated using the image. If the overlapping regions of the measurement images are not large, the results obtained by the measurement can be determined to be reliable.

Next, the evaluation methods for each sample of Examples and Comparative Examples will be described.

### (Cutter Service Life Evaluation Method)

Continuous ribbon bonding was performed using a bonder 3600Plus manufactured by ORTHODYNE Co., Ltd., on a copper plate having a length of 50 mm × width of 50 mm × thickness of 1 mm, at settings of a load of 2300 gf, a power (ultrasonic output setting) of 220, and a holding time of 150 milliseconds. For each sample, bonding was performed with a combination of a first bond and a second bond set as n = 1 (one set). At this time, when the bonder stopped due to a cutting error such as a remaining uncut portion of the copper ribbon at a number of bonding times of 5000 sets or less, it was rated as "F" in the sense of being failure. When the bonder stopped after exceeding 5000 sets and at 7000 sets or less of bonding times, it was rated as "B" in the sense of having no practical problem. When the bonder stopped after exceeding 7000 sets and at 10,000 sets or less of bonding times, it was rated as "A" in the sense of being good. When the bonder stopped after exceeding 10,000 sets of bonding times, it was rated as "S" in the sense of being excellent. These results are shown in Tables 1, 2, 3, and 4.

### (Bond Strength Evaluation Method)

Using a bonder 3600Plus manufactured by ORTHODYNE Co., Ltd., ten sets of bonding were performed in a semiconductor package having a semiconductor element (chip electrode) and a lead frame, with a combination of the semiconductor element (first bond) and the lead frame (second bond) as one set, at a holding load of 2300 gf, a power (ultrasonic output setting) of 220, and a holding time of 150 milliseconds. Then, the center of the bonding loop was cut, and peel tests were performed at the first bonding portion and the second bonding portion using a STELLAR 4000 manufactured by Nordson Advanced Technology Co., Ltd., and the number of samples was 20 (n = 20). The peel test was performed using a 5-kg load cell under a condition of a tensile speed of 300 µm/sec. Among the 20 samples, when not even one copper ribbon peeled off from the bonding portion (the number of peelings was 0), it was rated as "S" in the sense of being excellent. When the number of copper ribbons that did not peel off from the bonding portion was 15 to 19, that is, when the number of peelings of copper ribbons from the bonding portion was 1 to 5, it was rated as "A" in the sense of being good. When the number of copper ribbons that did not peel off from the bonding portion was 10 to 14, that is, when the number of peelings of copper ribbons from the bonding portion was 6 to 10, it was rated as "B" because the possibility of causing a practical problem is low although there are points to be improved. When the number of peelings of copper ribbons from the bonding portion was 11 or more, it was rated as "F" in the sense of being failure because the possibility of causing a practical problem is high. The evaluation results are shown in Tables 1, 2, 3, and 4.

### (Chip Damage Evaluation Method)

The chip damage evaluation was performed by bonding 20 sets of the semiconductor element (first bond) and the lead frame (second bond) under the same conditions as the above-mentioned bond evaluation method, and then, dissolving the metal film on the semiconductor element with chemicals, and observing the exposed chip electrode with a metallurgical microscope. When there were no cracks or scratches at all, it was rated as "S" in the sense of being very good. When there were no cracks but shallow scratches (traces) were present, it was rated as "A" in the sense of being good. When there were no cracks but scratches were present, it was rated as "B" in the sense of having no problem. When there was even one crack, it was rated as "F" in the sense of being failure. The evaluation results are shown in Tables 1, 2, 3, and 4.

### (Comprehensive Evaluation)

The comprehensive evaluation was determined as follows based on the five evaluations in Tables 1, 2, 3, and 4, and is described in Tables 1, 2, 3, and 4. If one or more "S"s were present among the five ratings and the others were "S" or "A," the comprehensive evaluation was denoted by a symbol "E" (Excellent) in the sense of being excellent. If there were three or more "B"s and no "F"s, the comprehensive evaluation was denoted by a symbol "P" (Passable), in the sense of being passable. In the case of a combination of "A," "S," and "B" other than the above, and where there was no "F"s, the comprehensive evaluation was denoted by a symbol "G" (Good), in the sense of being good. The comprehensive evaluation for sample having even one "F" rating was denoted by a symbol "F" (Fail), in the sense of being failure.
Specific combinations of the respective ratings (in no particular order) are as follows:
"E": SSSSS, SSSSA, SSSAA, SSAAA, SAAAA
"G": SSSSB, SSSAB, SSSBB, SSAAB, SSABB, SAAAB, SAABB, AAAAA, AAAAB, AAABB
"P": SSBBB, SABBB, SBBBB, AABBB, ABBBB, BBBBB
"F": any case where even one F is present.

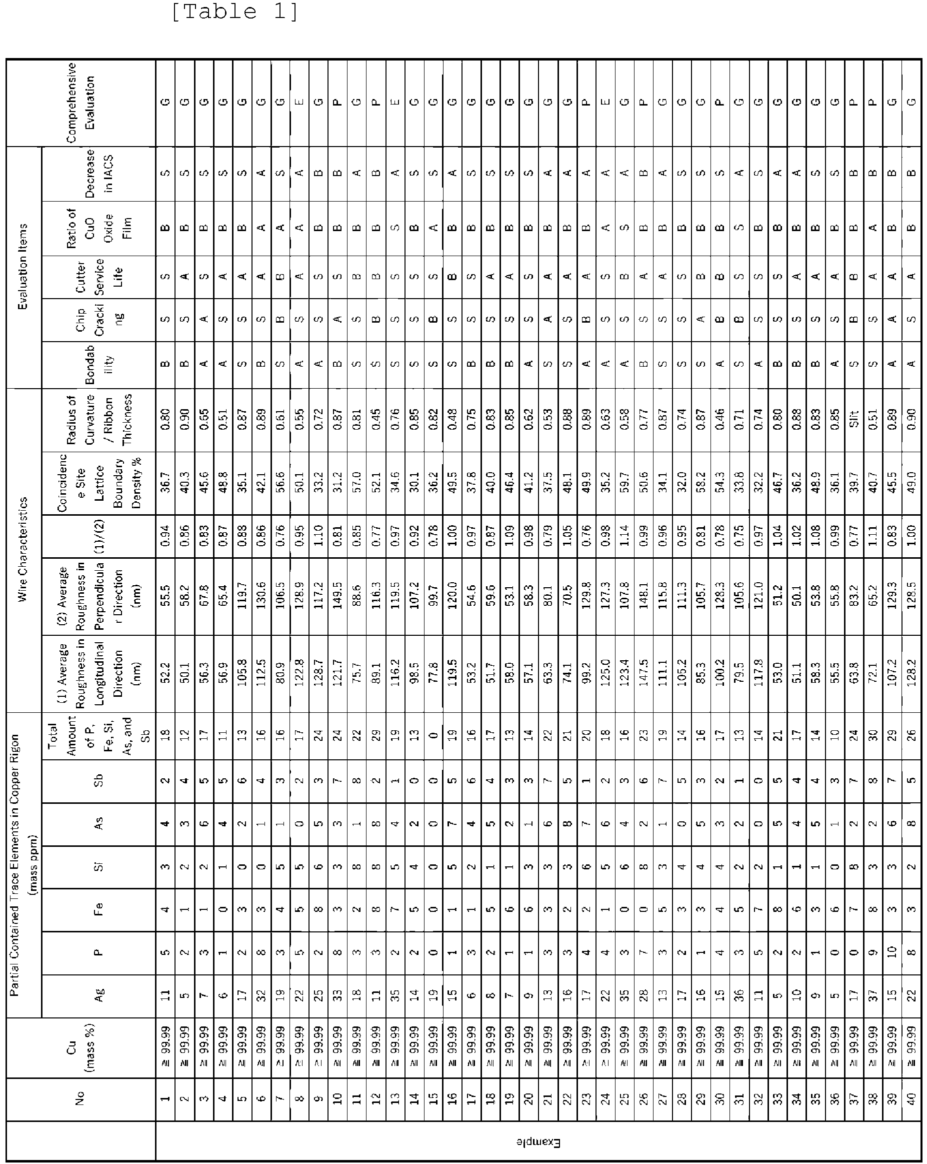

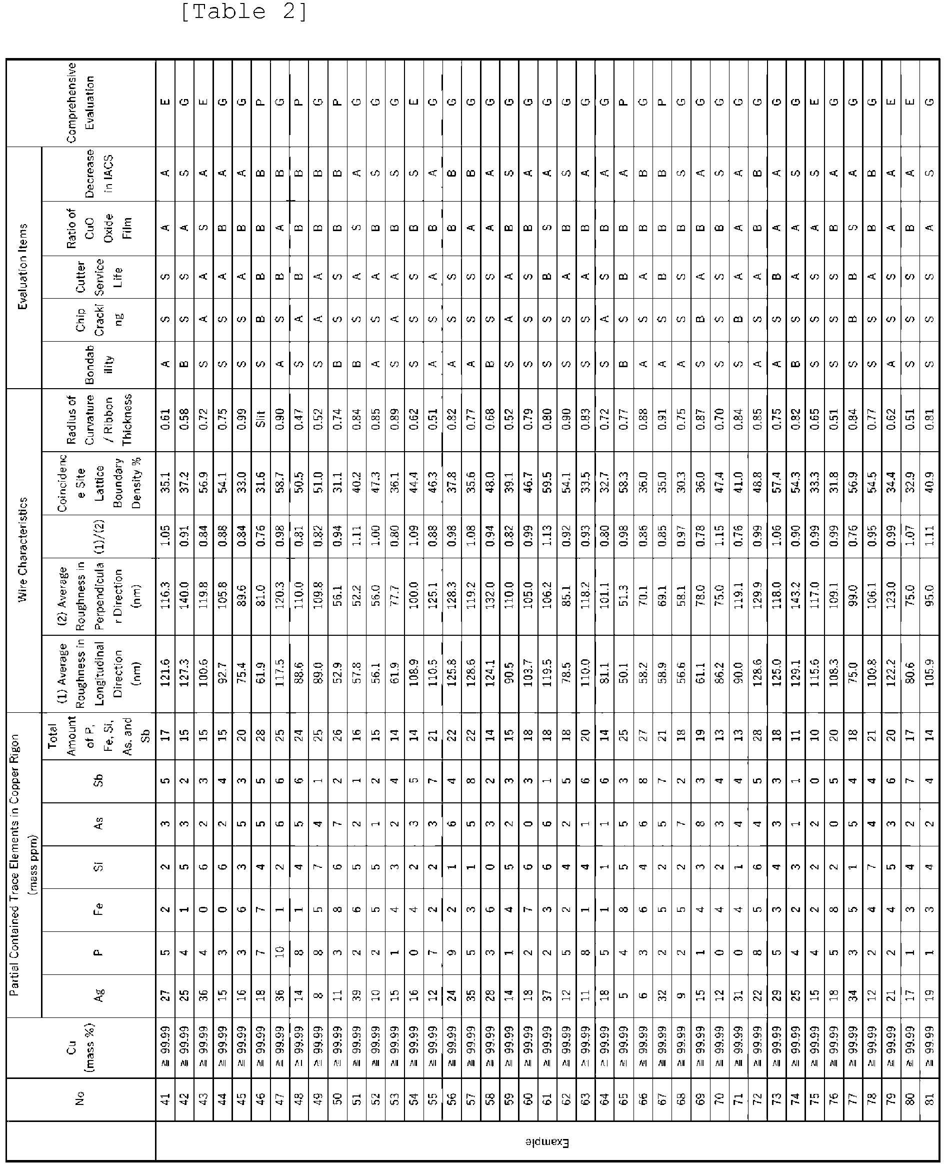

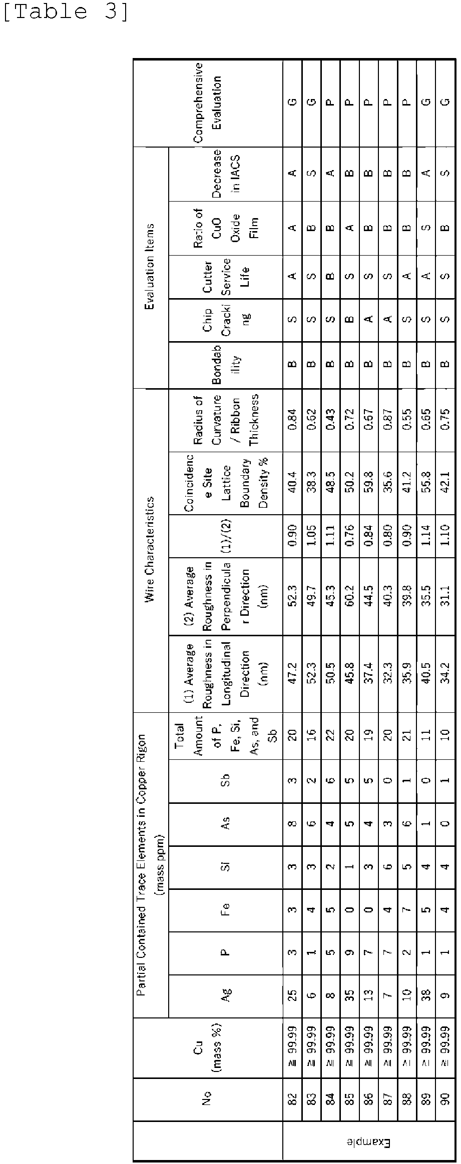

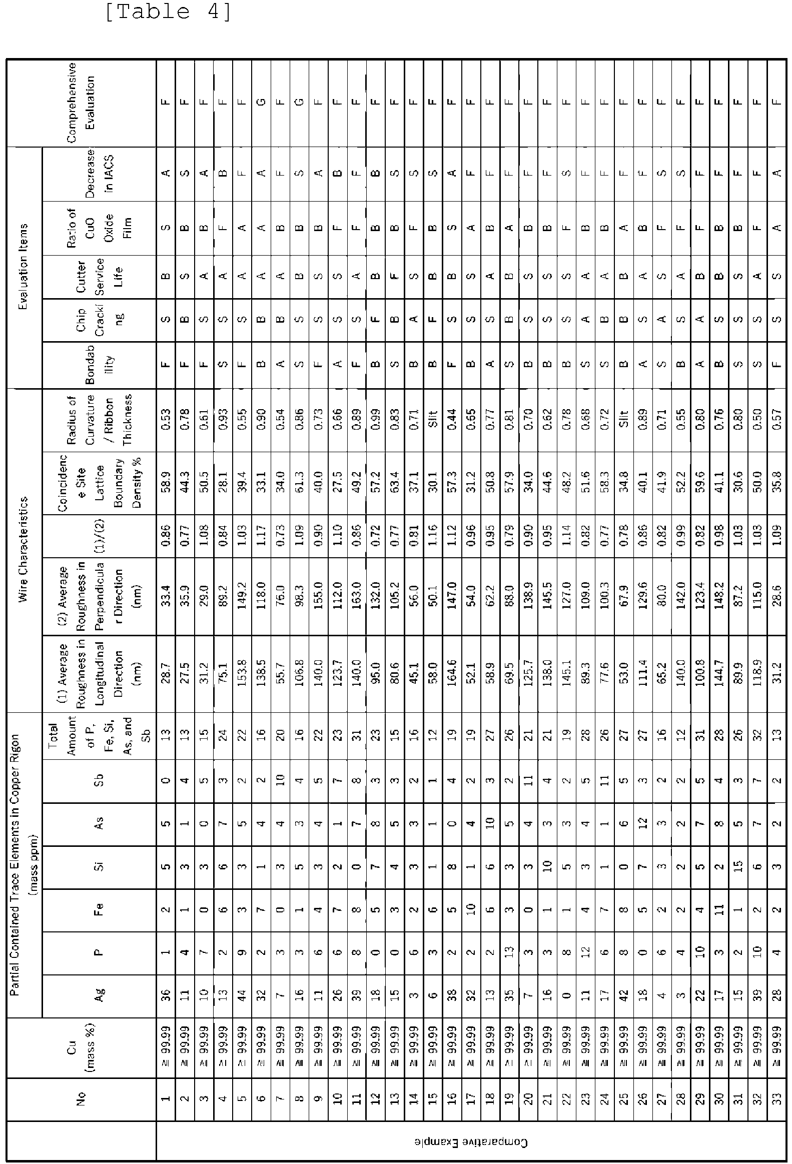

Table 1, Table 2, Table 3, and Table 4 show the purity of copper and the concentrations (content ratios) of partial contained elements in Examples and Comparative Examples. Each concentration was calculated by inductively coupled plasma mass spectrometry (Inductively Coupled Plasma-mass Spectrometry, ICP-MS) (8800 ICP-MS manufactured by Agilent Technologies Japan, Ltd.) owned by Tanaka Electronics Co., Ltd., the applicant.

### (Evaluation of Oxidation Resistance)

Next, the samples of Examples and Comparative Examples were evaluated for oxidation resistance as follows. Each sample of Examples and Comparative Examples was left for six months at a room temperature of 35°C and a humidity of 75%RH. Then, the oxidation state of the copper ribbon surface was analyzed. In the process of copper oxidation, copper(I) oxide (Cu₂O) is usually generated first, and the ratio of CuO increases as the oxidation proceeds. Therefore, the ease of oxidation generation (oxidation resistance) of the copper ribbon can be evaluated by calculating the ratio of the CuO oxide film. Note that the ratio of the CuO oxide film was obtained by converting "(CuO oxide film) / (CuO oxide film + Cu₂O oxide film)" into a percentage.

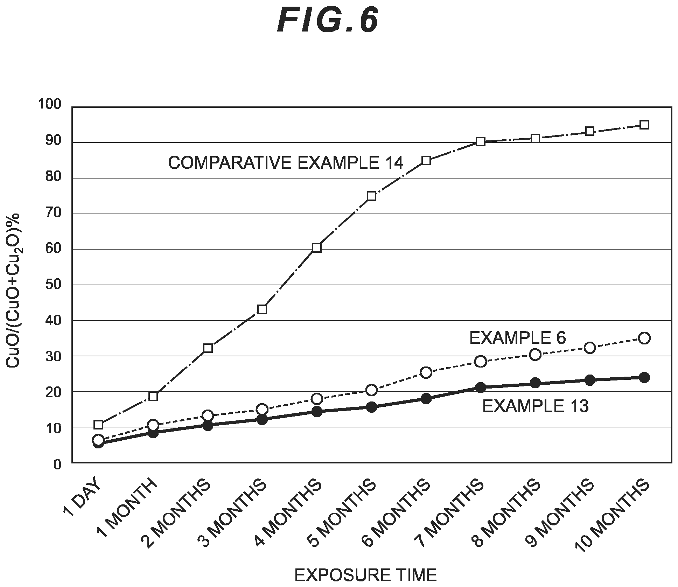

Fig. 6 is a graph showing changes with time in the ratio of the CuO oxide film of Example 6, Example 13, and Comparative Example 14 after the exposure test. In Fig. 6, white circles represent the results of Example 6, black circles represent the results of Example 13, and white squares represent the results of Comparative Example 14. As shown in Fig. 6, it can be seen that the copper ribbon of Example containing 5 mass ppm or more of silver has a lower rate of increase with time in the ratio of the CuO oxide film compared to the copper ribbon of Comparative Example containing less than 5 mass ppm of silver.

As the measurement result of the oxide film, a thickness conversion value calculated by sequential electrochemical reduction analysis (SERA: Sequential Electrochemical Reduction Analysis) was used. SERA analysis for determining the thicknesses of copper(II) oxide (CuO) and copper(I) oxide (Cu₂O) was performed by the following procedure using a QC -200 manufactured by ECI Technology. A copper ribbon was sandwiched between two O-rings, and a region with a diameter of 2.1 cm was isolated by a gasket, and a borate buffer solution was injected and saturated with nitrogen. A current density (I) of 150 µA/cm² was applied to the region, and the time (seconds) (t) required for the Cu₂O reduction reaction appearing at -0.30 V to -0.60 V and the CuO reduction reaction appearing at -0.60 V to -0.85 V were measured. The thicknesses T (nm) of CuO and Cu₂O were calculated on the basis of T = K·I·t using a constant K obtained from Faraday's law. Note that the value of constant K for CuO is 6.53 × 10⁻⁵ (cm^{3/}A·sec), and the value of K for Cu₂O is 2.45 × 10⁻⁴ (cm³/A·sec).

The measurement was performed on the surface at three locations: the periphery of the front end, the periphery of the rear end, and the midpoint part of the copper ribbon, and the average value thereof was obtained. A sample in which the ratio of the CuO oxide film was 20% or less was rated as "S" in the sense of being excellent. A sample in which the ratio of the CuO oxide film exceeded 20% and was 25% or less was rated as "A" in the sense of being good. A sample in which the ratio exceeded 25% and was 30% or less was rated as "B" in the sense of being at or above the minimum level for practical use. In addition, a case where the ratio exceeds 30% was rated as "F" in the sense that there is a high possibility that a defect will occur in practical use.

Here, the reason why the ratio of CuO oxide film of 30% or less was determined to be acceptable will be explained. In a power module, IGBTs, MOSFETs, and diode chips are mounted on a substrate in which a ceramic plate (silicon nitride, alumina, etc.) and a copper plate are integrated by bonding through an active metal brazing method (Active Metal Brazing: AMB) or a direct copper bonding method (Direct Copper Bonding: DCB), and a circuit is formed on the substrate by ribbon bonding.

For example, in a copper ribbon bonded onto a copper plate of a DCB substrate with a bonding wire, a temperature cycle test (for example, -65°C to 150°C) carried out in a finished product state where a silicone resin is encapsulated may cause a problem in which a force is applied to the ribbon bonding portion due to thermal expansion and thermal contraction of the silicone resin and the ribbon is caused to peel off. The temperature conditions of this temperature cycle test are determined by a global common on-vehicle standard. The present inventors surmised that growth of an oxide film on the surface of the copper ribbon due to heat is one of the main causes of this peeling. Then, the inventors have found that peeling of the ribbon bonding portion in the foregoing temperature cycle test can be greatly reduced if the ratio of the CuO film on the surface of the copper ribbon after the exposure test of the copper ribbon, that is, after standing at a room temperature of 35°C and a humidity of 75%RH for 6 months, is 30% or less.

Furthermore, in recent years, the operating guaranteed temperature range of power semiconductors has widened, and, for example, cases have emerged where a guarantee in the range of -65°C to 175°C is required. In these temperature cycle tests, a higher load is applied to the copper ribbon than in the test conditions described above, and ribbon peeling from the bonding portion is likely to occur. The present inventors have discovered that when the ratio of the CuO oxide film on the surface of the ribbon can be suppressed to 30% or less in the exposure test described above, such a high requirement is satisfied, and ribbon peeling from the bonding portion does not occur even under more severe conditions, and stable bond strength can be obtained.

In addition to the problem of ribbon peeling due to the generation of the copper oxide film, the present inventors have found that the expansion of the aforementioned guaranteed temperature range can cause a problem of reduction in electrical conductivity at high temperatures. That is, the electrical conductivity tends to decrease as the temperature increases. As described above, the copper ribbon of the embodiment has a larger volume than a copper wire, and therefore has an advantage that a large current can flow at a high voltage. However, if the electrical resistance increases and the electrical conductivity decreases due to an increase in temperature, the current value may decrease and the driving force may decrease.

Therefore, in manufacturing of a power semiconductor device, it is necessary to quantitatively predict the increase in the electrical resistance of the copper ribbon at a higher temperature. If the electrical resistance increases more than the predicted value, not only can the current value not be realized according to the design, but also the heat generated by the ribbon due to the increase in the electrical resistance may adversely affect peripheral members. For example, there may occur a serious problem such that the sealing resin as a peripheral member melts due to the heat generated by the ribbon.

The present inventors repeatedly conducted earnest research and experiments on the rate of increase in electrical resistance of the copper ribbon and the heat generation accompanying it, particularly regarding the high-temperature range as the guaranteed temperature range is expanded. As a result, the inventors have discovered that if the electrical conductivity (IACS) at room temperature is 99% or more (preferably 99.5% or more), the electrical resistance remains within the range of increase in electrical resistance (not exceeding approximately 1.7 times) assumed for a normal temperature increase in manufacturing of a power semiconductor device.

In addition, in order to suppress the increase in electrical resistance and to suppress the ratio of the CuO oxide film on the surface of the copper ribbon to 30% or less, the present inventors repeatedly conducted experiments to evaluate the electrical resistance and the generation of the CuO oxide film by micro-alloying various elements into high-purity copper, in addition to controlling the above-mentioned coincidence site lattice boundary density. As a result, the inventors have found that these two problems can be solved simultaneously by containing silver (Ag) in an amount of 5 mass ppm or more and 40 mass ppm or less, phosphorus (P) in an amount of 0 mass ppm or more and 10 mass ppm or less, and iron (Fe), silicon (Si), arsenic (As) and antimony (Sb) each contained in an amount of 0 mass ppm or more and 8 mass ppm or less, with respect to the entire copper ribbon, and by satisfying the condition where the total of the aforementioned elements other than silver (Ag) is 0 mass ppm or more and 30 mass ppm or less.

The electrical conductivity was measured at corresponding locations in terms of IACS (International Annealed Copper Standard) conductivity, and an average value was obtained. In the IACS, the electrical resistivity of each copper ribbon is determined by the four-point probe method using a distance between potential lead wires of 100 mm and a DC current of 200 mA, and the value of the electrical resistivity of each copper ribbon is expressed as a ratio when the IACS is 100% at an electrical resistivity of 1.7241 × 10⁻² µΩm for standard annealed soft copper at room temperature (20°C). A sample in which the rate of decrease in IACS was less than 0.5% compared with the IACS of copper with a purity of 99.999 mass % was rated as "S" in the sense of being excellent. A sample in which the rate of decrease in IACS was 0.5% or more and less than 0.8% was rated as "A" in the sense of being good. Further, a case where the rate of decrease in IACS was 0.8% or more and less than 1.0% was rated as "B" in the sense of being at or above the minimum level for practical use, and a case where the rate of decrease in IACS was 1.0% or more was rated as "F" in the sense that there is a high possibility that a defect will occur in practical use.

Here, the results of Examples and Comparative Examples are discussed. First, the effect of the coincidence site lattice boundary density is examined. The copper ribbon of Example 25 (Table 1) has a coincidence site lattice boundary density of 59.7%, and the copper ribbon of Comparative Example 29 (Table 3) has a coincidence site lattice boundary density of 59.6%, and the cutter service life is rated as "B" (no problem in practical use) in both cases. On the other hand, the copper ribbon of Comparative Example 8 has a coincidence site lattice boundary density of 61.3%, and the copper ribbon of Comparative Example 13 has a coincidence site lattice boundary density of 63.4%, and the cutter service life is rated as "F" (failure: bonder stopped due to cutting error) in both cases. From these results, it can be seen that, when the coincidence site lattice boundary density is less than 60%, with 60% as a critical value, the extension of the cutter service life is remarkably excellent.

In addition, exposure tests were carried out specifically on samples, particularly, having a low coincidence site lattice boundary density. As a result, the CuO oxide film on the sample surface after exposure tests on the copper ribbons with coincidence site lattice boundary densities of 30.1% (Example 14) and 30.3% (Example 68) was rated as "B" (at or above the minimum level for practical use), while the CuO oxide film on the copper ribbons with coincidence site lattice boundary densities of 28.1% (Comparative Example 4) and 27.5% (Comparative Example 10) was rated as "F" (failure). From these results, it can be seen that with the coincidence site lattice boundary density of 30% as a boundary, the oxidation resistance of the copper ribbons is unexpectedly and remarkably excellent when the coincidence site lattice boundary density is 30% or more.

Next, the influence of the radius of curvature of the end face will be examined. The copper ribbons of Example 37, Example 46, Comparative Example 15, and Comparative Example 25, on which slit processing was performed to have linear end faces, were expected to have excellent cutter service life because their coincidence site lattice boundary densities were as small as 30% range, but the cutter service life was rated as "B" (no practical problem), a relatively low rating. On the other hand, for the copper ribbons of Example 3 (coincidence site lattice boundary density of 45.6%) and Example 33 (coincidence site lattice boundary density of 46.7%), in which the coincidence site lattice boundary densities were in the 40% range, it was estimated that extension of the cutter service life due to the coincidence site lattice boundary density could not be expected as much as those in the 30% range, but the cutter service life was rated as "S" (excellent) because the end faces were arc-shaped.

In Example 66, the coincidence site lattice boundary density is 36.0% and a value obtained by dividing the radius of curvature by the thickness of the copper ribbon is 0.88, and the cutter service life is rated as "A" (excellent). On the other hand, in Example 67 having a comparable coincidence site lattice boundary density (35.0%), the value obtained by dividing the radius of curvature by the thickness of the copper ribbon is 0.91, and the cutter service life is rated as "B" (no practical problem). From these results, it is understood that the rating of the cutter service life is further improved when the value obtained by dividing the radius of curvature by the thickness of the copper ribbon is 0.90 or less with the value of 0.90 as a boundary.

In Example 4, for example, the coincidence site lattice boundary density is 48.8%, the value obtained by dividing the radius of curvature by the thickness of the copper ribbon is 0.51, and the cutter service life is rated as "A" (good). Similarly, in Example 49, the coincidence site lattice boundary density is 51.0%, the value obtained by dividing the radius of curvature by the thickness of the copper ribbon is 0.52, and the cutter service life is rated as "A." On the other hand, in Example 16, the coincidence site lattice boundary density is 49.5%, the value obtained by dividing the radius of curvature by the thickness of the copper ribbon is 0.48, and the cutter service life is rated as "B" (no practical problem). Similarly, in Example 48, the coincidence site lattice boundary density is 50.5%, and the value obtained by dividing the radius of curvature by the thickness of the copper ribbon is 0.47. The cutter service life is rated as "B." Incidentally, the rating "B" for the cutter service life here was given because it was confirmed that there was a slight warpage in the ribbon, although it does not pose a practical problem. From these results, it is understood that the rating of the cutter service life is more excellent when the value obtained by dividing the radius of curvature by the thickness of the copper ribbon is 0.50 or more with the value of 0.50 as a boundary.

Next, the average roughness will be examined. For example, in Example 87, the average roughness in the longitudinal direction was 32.3 nm, the average roughness in the direction perpendicular to the longitudinal direction was 40.3 nm, and the bondability was rated as "B" (low possibility of causing practical problems). Similarly, in Example 90, the average roughness in the longitudinal direction was 34.2 nm, the average roughness in the direction perpendicular to the longitudinal direction was 31.1 nm, and the bondability was rated as "B." On the other hand, in Comparative Example 1, the average roughness in the longitudinal direction was 28.7 nm, the average roughness in the direction perpendicular to the longitudinal direction was 33.4 nm, and the bondability was rated as "F" (failure). In Comparative Example 3, the average roughness in the longitudinal direction was 31.2 nm, the average roughness in the direction perpendicular to the longitudinal direction was 29.0 nm, and the bondability was rated as "F." From the above, it can be seen that the bondability is remarkably excellent when the average roughness in the longitudinal direction and the average roughness in the direction perpendicular to the longitudinal direction are 30.0 nm or more with 30.0 nm as a critical value.

In Example 26, the average roughness in the longitudinal direction was 147.5 nm, the average roughness in the direction perpendicular to the longitudinal direction was 148.1 nm, and the bondability was rated as "B" (low possibility of causing practical problems). In Example 10, the average roughness in the longitudinal direction was 121.7 nm, the average roughness in the direction perpendicular to the longitudinal direction was 149.5 nm, and the bondability was rated as "B." On the other hand, in Comparative Example 5, the average roughness in the longitudinal direction was 153.8 nm, the average roughness in the direction perpendicular to the longitudinal direction was 149.2 nm, and the bondability was rated as "F" (failure). In Comparative Example 9, the average roughness in the longitudinal direction was 140.0 nm, the average roughness in the direction perpendicular to the longitudinal direction was 155.0 nm, and the bondability was rated as "F." From the above, it is understood that the bondability is remarkably excellent when the average roughness in the longitudinal direction and the average roughness in the direction perpendicular to the longitudinal direction are 150 nm or less with 150 nm as a critical value.

Next, oxidation resistance and electrical conductivity will be examined. For example, in Example 2, the silver content was 5 mass ppm, the CuO oxide film ratio was rated as "B" (at or above the minimum level for practical use), and the decrease in IACS value (electrical conductivity) was rated as "S" (excellent). On the other hand, in Comparative Example 27, the silver content was 4 mass ppm, the decrease in IACS value was rated as "S," but the CuO oxide film was rated as "F" (high possibility that a defect will occur in practical use). Further, in Example 51, the silver content was 39 mass ppm, the CuO oxide film ratio was rated as "S" (excellent), and the decrease in IACS value was rated as "A" (good). On the other hand, in Comparative Example 25, the silver content was 42 mass ppm, the CuO oxide film ratio was rated as "A", but the decrease in IACS value was rated as "F." From these results, it is understood that the silver content is preferably 5 mass ppm or more and 40 mass ppm or less.

In Example 36, the phosphorus content was 0 mass ppm, the CuO oxide film ratio was rated as "B," and the decrease in IACS value was rated as "S," In Example 39, the phosphorus content was 10 mass ppm, the CuO oxide film ratio was rated as "B," and the decrease in IACS value was also rated as "B." On the other hand, in Comparative Example 23, the phosphorus content was 12 mass ppm, the CuO oxide film was rated as "B," but the decrease in IACS value was rated as "F." From these results, it is understood that the phosphorus content is preferably 0 mass ppm or more and 10 mass ppm or less.

In Example 4, the iron content was 0 mass ppm, the CuO oxide film ratio was rated as "B," and the decrease in IACS value was rated as "S." In Example 9, the iron content was 8 mass ppm, the CuO oxide film ratio was rated as "B," and the decrease in IACS value was rated as "B." On the other hand, in Comparative Example 17, the iron content was 10 mass ppm, the CuO oxide film ratio was rated as "A," but the decrease in IACS value was rated as "F."
Thus, it is understood that the iron content is preferably 0 mass ppm or more and 8 mass ppm or less.

In Example 5, the silicon content was 0 mass ppm, the CuO oxide film ratio was rated as "B," and the decrease in IACS value was rated as "S." In Example 11, the silicon content was 8 mass ppm, but the CuO oxide film ratio was rated as "B," and the decrease in IACS value was rated as "A." On the other hand, in Comparative Example 21, the silicon content was 10 mass ppm. Although the CuO oxide film ratio was rated as "B," the decrease in IACS value was rated as "F." From these results, it is understood that the silicon content is preferably 0 mass ppm or more and 8 mass ppm or less.

In Example 8, the arsenic content was 0 mass ppm, the CuO oxide film ratio was rated as "A," and the decrease in IACS value was rated as "A." In Example 22, the arsenic content was 8 mass ppm, but the CuO oxide film ratio was rated as "B," and the decrease in IACS value was rated as "A." On the other hand, in Comparative Example 18, the arsenic content was 10 mass ppm, and the CuO oxide film ratio was rated as "B," but the decrease in IACS value was rated as "F." Thus, it is understood that the arsenic content is preferably 0 mass ppm or more and 8 mass ppm or less.

In Example 14, the antimony content was 0 ppm by mass, the CuO oxide film ratio was rated as "B," and the decrease in IACS value was rated as "S." In Example 57, the antimony content was 8 ppm by mass, but the CuO oxide film ratio was rated as "A," and the decrease in IACS value was rated as "B." On the other hand, in Comparative Example 7, the antimony content was 10 ppm by mass, and the CuO oxide film was rated as "B," but the decrease in IACS value was rated as "F." From these results, it is understood that the antimony content is preferably 0 mass ppm or more and 8 ppm by mass or less.

In Example 15, the total content of phosphorus, iron, silicon, arsenic, and antimony was 0 ppm by mass, the CuO oxide film ratio was rated as "A," and the decrease in IACS value was rated as "S." In Example 38, the total content of phosphorus, iron, silicon, arsenic, and antimony was 30 ppm by mass, but the CuO oxide film ratio was rated as "A," and the decrease in IACS value was rated as "B." On the other hand, in Comparative Example 29, the total content of phosphorus, iron, silicon, arsenic, and antimony was 31 ppm by mass, the CuO oxide film was rated as "F," and the decrease in IACS value was rated as "F." As a result, it is understood that the total content of phosphorus, iron, silicon, arsenic and antimony is preferably 0 mass ppm or more and 30 ppm by mass or less.

Next, a case where the copper ribbons of Examples are applied to a connection between a bus bar of a lithium-ion battery module used in an electric vehicle and an electrode of a lithium-ion battery will be described. In a lithium-ion battery, several tens of columnar lithium ion batteries are used as one unit, and a gel-like substance is filled in gaps between adjacent lithium ion batteries to avoid contact between the adjacent batteries and to absorb vibration during driving of an automobile.

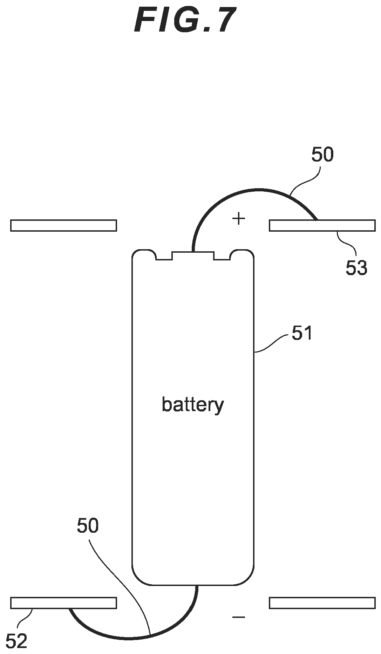

Fig. 7 is a diagram schematically illustrating a part of the lithium-ion battery module. The lithium-ion battery module illustrated in Fig. 7 includes a lithium-ion battery 51, a negative electrode-side bus bar 52, a positive electrode-side bus bar 53, and a copper ribbon 50 that electrically connects the lithium-ion battery 51 and the negative electrode-side bus bar 52. The lithium-ion battery module illustrated in Fig. 7 further includes another copper ribbon 50 that electrically connects the lithium-ion battery 51 and the positive electrode-side bus bar 53. As the copper ribbon 50, the copper ribbon of the embodiment described above is used. The lithium-ion battery module illustrated in Fig. 7 is mounted on a vehicle with the positive and negative electrodes arranged on the top surface and the bottom surface of a columnar lithium-ion battery, respectively, and usually, with the positive electrode located on an upper side and the negative electrode located on a lower side.

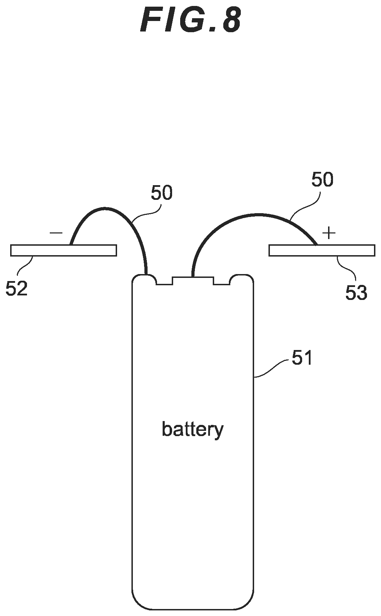

Fig. 8 is a diagram schematically illustrating a part of a lithium-ion battery module of another embodiment. The lithium-ion battery module illustrated in Fig. 8 includes a lithium-ion battery 51, a negative electrode-side bus bar 52, a positive electrode-side bus bar 53, and a copper ribbon 50 for electrically connecting the lithium-ion battery 51 and the negative electrode-side bus bar 52. The lithium-ion battery module illustrated in Fig. 8 further includes another copper ribbon 50 for electrically connecting the lithium-ion battery 51 and the positive electrode-side bus bar 53. As the copper ribbon 50, the copper ribbon of the embodiment described above is used. The lithium-ion battery module illustrated in Fig. 8 is mounted on a vehicle with both the positive and negative electrodes arranged at the center and the outer edge of the upper surface of the columnar lithium-ion battery, respectively, and usually, with the positive electrode located on an upper side.

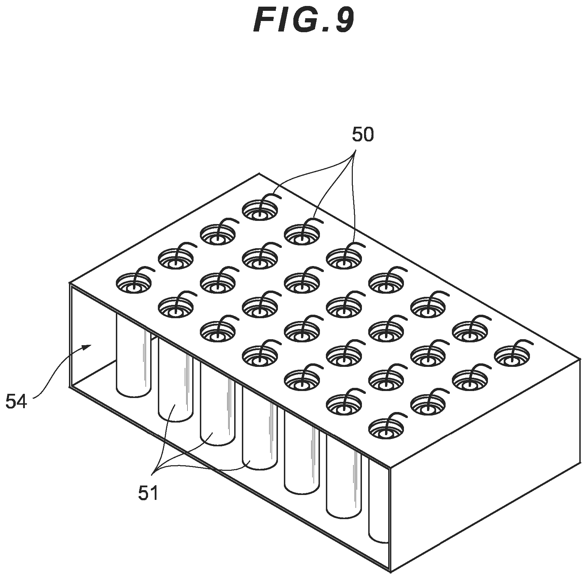

Fig. 9 is a diagram schematically illustrating the entire lithium-ion battery module. As illustrated in Fig. 9, the lithium-ion battery module is configured by housing a plurality of lithium-ion batteries 51 and filling a gel-like substance 54 between the plurality of lithium-ion batteries 51. A copper ribbon 50 is connected to the lithium-ion battery 51.

In bonding between the bus bar and the copper ribbon in the lithium-ion battery module and bonding between the electrode of the lithium-ion battery and the copper ribbon (ribbon bonding), when using the copper ribbon of Example having good bondability, they can maintain good bond strength. The reason is as follows, for example. Since ultrasonic waves are used in ribbon bonding, and since the lithium-ion batteries are not fixed by the gel-like substance, the lithium-ion batteries themselves undergo ultrasonic vibration during the bonding process. Therefore, if the bondability is weak, the copper ribbon peels off from the bonding portion. In addition, not only during bonding but also against vibration during automobile traveling, when the copper ribbon of the Examples with high bondability is used, peeling and breakage from the bonding portion can be avoided.

Furthermore, since automobiles are used in harsh environments from deserts to tropical rainforests and cold regions, bonding ribbons mounted on automobiles are also susceptible to corrosion (oxidation). The copper ribbon of the present embodiment has a function of suppressing generation of CuO, and is suitable for bonding between a bus bar of a lithium-ion battery module used in an electric vehicle and an electrode of a lithium-ion battery from the viewpoint of oxidation resistance and corrosion resistance.

As illustrated in Fig. 9, since a lithium battery module is an aggregate of many lithium ion batteries, the number of cuts of a copper ribbon is also large. Therefore, since the copper ribbon of the present embodiment also has an effect of extending the service life of a cutter, it is extremely suitable for a lithium battery module.

Furthermore, since a copper ribbon with low electrical resistance (high electrical conductivity) as in the present embodiment does not easily generate heat, the safety of lithium-ion batteries, which pose a risk of explosion due to high heat (for example, 80°C or higher), can be improved.

### (Evaluation of Bondability between Battery Electrode and Bus Bar)

Using the copper ribbons of Examples 1 to 90 and Comparative Examples 1 to 33, a bonding mode between a lithium-ion battery electrode and a bus bar was simulated. Using two copper plates, a first bonding was performed on the first plate, and then a second bonding was performed on the second plate set at a position about 20 mm lower than the first plate. Except for a difference in a positional relationship between the first bonding and the second bonding, bondability and a cutter service life were evaluated under the same conditions as in the present Examples using the same bonder 3600Plus manufactured by ORTHODYNE Co., Ltd. as in the above Examples. As a result, the evaluation results were the same as those in Tables 1, 2, 3, and 4.

As described above, the copper ribbons of the embodiments were able to simultaneously solve the problems of good bondability, suppression of chip cracking, extension of a cutter service life of a bonder, suppression of CuO oxide film generation, and suppression of decrease in IACS value by controlling the trace elements and their concentrations, surface average roughness, an aspect ratio of surface average roughness, and a coincidence site lattice boundary density within respective predetermined ranges in bonding in a power semiconductor device or the like.

In addition, since the copper ribbon of the embodiment is excellent in bondability, a generation ratio of the CuO oxide film is low, bond strength is high, and electrical conductivity is high and heat is not easily generated, it is extremely suitable not only for power semiconductor applications but also for bonding between a bus bar of a lithium-ion battery module of an electric vehicle and an electrode of a lithium-ion battery.

By the copper ribbon of the present embodiment, it is possible to greatly contribute to development of an automobile industry, a power electronics industry, an electric railway industry, an electric power industry, and the like, and consequently, to greatly contribute to the reduction of greenhouse gas emissions and the prevention of global warming.

### Reference Signs List

100, 101 ... semiconductor device, 1 ... semiconductor element, 2 ... metal film, 3 ... ribbon, 41 ... circuit pattern, 42 ... metal pattern, 43 ... insulating member, 5 ... heat dissipation member, 6 ... bonding material, 7 ... case, 8 ... terminal, 9 ... sealing material, LF ... lead frame, 50 ... copper ribbon, 51 ... lithium-ion battery, 52 ... electrode-side bus bar, 53 ... positive electrode-side bus bar, 54 ... gel-like material 54

## Claims

1. A copper bonding ribbon comprising a copper alloy having a copper purity of 99.99 mass % or more, wherein
the copper alloy contains, relative to a total amount, 5 mass ppm or more and 40 mass ppm or less of silver (Ag), 0 mass ppm or more and 10 mass ppm or less of phosphorus (P), and 0 mass ppm or more and 8 mass ppm or less of each of iron (Fe), silicon (Si), arsenic (As), and antimony (Sb), with a total content of phosphorus (P), iron (Fe), silicon (Si), arsenic (As), and antimony (Sb) being 0 mass ppm or more and 30 mass ppm,
in a cross section perpendicular to a longitudinal direction of the copper bonding ribbon, a ratio of a coincidence site lattice boundary length to a total length of crystal grain boundaries is 30% or more and less than 60%,
(1) an arithmetic average roughness (Ra) of a plane of the copper bonding ribbon in the longitudinal direction is 30 nm or more and 150 nm or less,
(2) an arithmetic average roughness (Ra) of the plane of the copper bonding ribbon in the direction perpendicular to the longitudinal direction is 30 nm or more and 150 nm or less, and
a value obtained by dividing (1) an arithmetic average roughness (Ra) in the longitudinal direction by (2) an arithmetic average roughness (Ra) in the direction perpendicular to the longitudinal direction is 0.75 or more and 1.15 or less.

2. The copper bonding ribbon according to claim 1, wherein an end face of the copper bonding ribbon has a curvature.

3. The copper bonding ribbon according to claim 1 or 2, wherein a value obtained by dividing a radius of curvature by a thickness of the copper bonding ribbon is 0.50 or more and 0.90 or less.

4. The copper bonding ribbon according to claim 1 or 2, wherein a width of the copper bonding ribbon is 0.3 mm or more and 5.0 mm or less and a thickness is 0.05 mm or more and 0.5 mm or less.

5. A method for manufacturing a copper ribbon, comprising the steps of:
preparing a bare copper wire comprising a copper alloy having a copper purity of 99.99 mass % or more, the bare copper wire containing, relative to a total amount, 5 mass ppm or more and 40 mass ppm or less of silver (Ag), 0 mass ppm or more and 10 mass ppm or less of phosphorus (P), and 0 mass ppm or more and 8 mass ppm or less of each of iron (Fe), silicon (Si), arsenic (As), and antimony (Sb), with a total content of phosphorus (P), iron (Fe), silicon (Si), arsenic (As), and antimony (Sb) being 0 mass ppm or more and 30 mass ppm;
drawing the bare copper wire to obtain a copper wire;
rolling the copper wire to form a copper ribbon; and
subjecting the copper ribbon to a final heat treatment by direct resistance heating, wherein
in a cross section perpendicular to a longitudinal direction of the copper bonding ribbon, a ratio of a coincidence site lattice boundary length to a total length of crystal grain boundaries is 30% or more and less than 60%,
(1) an arithmetic average roughness (Ra) of a plane of the copper bonding ribbon in the longitudinal direction is 30 nm or more and 150 nm or less,
(2) an arithmetic average roughness (Ra) of the plane of the copper bonding ribbon in a direction perpendicular to the longitudinal direction is 30 nm or more and 150 nm or less, and
a value obtained by dividing (1) an arithmetic average roughness (Ra) in the longitudinal direction by (2) an arithmetic average roughness (Ra) in the direction perpendicular to the longitudinal direction is 0.75 or more and 1.15 or less.

6. A power semiconductor device comprising: at least one substrate; at least one semiconductor element on the substrate; an electrode on a surface of the semiconductor element; an on-semiconductor-element substrate on the semiconductor element; at least one circuit pattern on the substrate; and
a copper bonding ribbon configured to connect one or more selected from the group consisting of electrodes on the surface of the semiconductor element to each other; an electrode on the surface of the semiconductor element and an external electrode; an electrode on the surface of the semiconductor element and one of the circuit patterns; an electrode on the surface of the semiconductor element and a terminal; two adjacent circuit patterns of the circuit patterns to each other; one of the circuit patterns and a terminal; the substrates to each other; and the on-semiconductor-element substrate and a circuit pattern, wherein
the copper bonding ribbon comprises a copper alloy having a copper purity of 99.99 mass % or more,
the copper alloy containing, relative to the total amount, 5 mass ppm or more and 40 mass ppm or less of silver (Ag), 0 mass ppm or more and 10 mass ppm or less of phosphorus (P), and 0 mass ppm or more and 8 mass ppm or less of each of iron (Fe), silicon (Si), arsenic (As), and antimony (Sb), with a total content of phosphorus (P), iron (Fe), silicon (Si), arsenic (As), and antimony (Sb) being 0 mass ppm or more and 30 mass ppm,
in a cross section perpendicular to a longitudinal direction of the copper bonding ribbon, the ratio of the coincidence site lattice boundary length to the total length of the crystal grain boundaries is 30% or more and less than 60%,
(1) an arithmetic average roughness (Ra) of a plane of the copper bonding ribbon in the longitudinal direction is 30 nm or more and 150 nm or less,
(2) an arithmetic average roughness (Ra) of the plane of the copper bonding ribbon in a direction perpendicular to the longitudinal direction is 30 nm or more and 150 nm or less, and
a value obtained by dividing (1) an arithmetic average roughness (Ra) in the longitudinal direction by (2) an arithmetic average roughness (Ra) in the direction perpendicular to the longitudinal direction is 0.75 or more and 1.15 or less
